# EUROPEAN PATENT APPLICATION

(11) **EP 1 492 160 A1**
(43) Date of publication of application: **29.12.2004**
(21) Application number: 03708661.8
(22) Date of filing: 18.03.2003
(51) Int. Cl.: H01L 21/205

(54) **VAPORIZER, VARIOUS DEVICES USING THE SAME, AND VAPORIZING METHOD**

(30) Priority: 18.03.2002 JP 2002075263
(71) Applicant: KABUSHIKI KAISHA WATANABE SHOKO, Chuo-ku, Tokyo 103-0022 (JP)
(72) Inventor: YAMOTO, Hisayoshi; c/o WACOM ELECTRIC CO., LTD, Chuo-ku, Tokyo 103-0022 (JP); KUSUHARA, Mitsuru; c/o WACOM ELECTRIC CO., LTD, Chuo-ku, Tokyo 103-0022 (JP); TODA, Masayuki, Yonezawa-shi, Yamagata 992-0026 (JP)
(74) Representative: Dr. Weitzel & Partner
(86) International application number: PCT/JP2003/003271
(87) International publication number: WO 2003/079422

(57) **Abstract**

There is provided a vaporizer that can be used for a long period of time without being clogged and can supply a raw material stably to a reaction section. The evaporator includes a dispersion section 8 having a gas passage 2 formed in a dispersion section body 1, a gas introduction port 4 for introducing a pressurized carrier gas 3 into the gas passage 2, means 6 for supplying a raw material solution 5 to the gas carrier passing through the gas passage 2, a gas outlet 7 for sending the carrier gas containing the dispersed raw material solution 5 to a vaporization section 22, and means 18 for cooling the gas passage 2; and the vaporization section 22 for heating and vaporizing the carrier gas in which the raw material solution is dispersed, having a vaporization tube 20 connected to the reaction section of an apparatus and the gas outlet 7 of the dispersion section 8, and a heater 21 for heating the vaporization tube 20, and is characterized in that the pressure of the reaction section is set lower than the pressure of the vaporization tube.

## Description

### TECHNICAL FIELD

The present invention relates to a vaporizer suitably used for a film forming apparatus such as a MOCVD film forming apparatus and a vaporizing method, and a CVD thin film forming apparatus and other various types of apparatuses.

### BACKGROUND ART

A problem arising in the development of DRAM is a decrease in storage capacitance caused by miniaturization. From the viewpoint of software error, capacitance of the same level as that of the old generation is required, so that it is necessary to take some measures. As the measures, although the cell structure up to 1M has been a planar structure, from 4M, a three-dimensional structure called a stack structure or a trench structure has been adopted to increase the capacitor area. Also, for the dielectric film, which has conventionally been a thermally-oxidized film of substrate Si, a film formed by laminating a thermally-oxidized film and a CVD nitrided film on poly Si (this laminated film is generally called an ON film) has been adopted. For 16M DRAM, in order to further increase the area contributing to the capacitance, for the stack type, a three-dimensional type in which the side surface is used, a fin type in which the back surface of plate is used, and the like type have been used.

In such a three-dimensional structure, however, there arises a problem in that the number of processes increases due to the complication of process and the yield decreases due to the increase in height difference. For this reason, it is said that it is difficult to realize DRAM of 256M bits or higher capacitance. Therefore, as one means for further increasing the degree of integration without changing the present structure of DRAM, there has been devised a method in which the dielectric of capacitance is changed over to one having a large dielectric constant. As a dielectric thin film having a large dielectric constant, attention was first paid to a thin film of a large dielectric constant single metal paraelectric oxide such as Ta₂O₅, Y₂O₃, and HfO₂. The specific dielectric constant of Ta₂O₅ is 28, that of Y₂O₃ is 16, that of HfO₂ is about 24, which are four to seven times that of SiO₂.

However, in application to DRAM of 256M or higher, a three-dimensional capacitor structure is needed. As a material which has a far larger specific dielectric constant than that of these oxides and is expected to be applied to DRAM, three kinds of (BaₓSr₁₋ₓ)TiO₃, Pb(Zr_{y}Ti_{1-y})O₃, and (PbₐL₁₋ₐ-) (Zr_{b}Ti_{1-b})O₃ have been regarded as very likely. A Bi-based laminar structure having a crystalline structure highly similar to that of a superconductive material has recently received great attention because it has a large dielectric constant and self polarization of ferroelectric characteristic, and hence it is superior as a nonvolatile memory.

Generally, SrBi₂TaO₉ ferroelectic thin film is formed by the MOCVD (metal organic chemical vapor deposition) method which is practical and promising.

The raw materials for the ferroelectic thin film are, for example, three kinds of organic metal complexes of Sr(DPM)₂, Bi(C₆H₅)₃, and Ta(OC₃H₅)₅. Each of these materials is used as a raw material solution by being dissolved in THF (tetrahydrofuran), hexane, or other solvents. Sr(Ta(OEt)6)₂ and Bi(OtAm)₃ are also used as a raw material solution by being dissolved in hexane or other solvents. DPM is the abbreviation of dipivaloylmethane.

The material properties of these raw materials are given in Table 1.

**[Table 1]**

| Properties of raw material for ferroelectric thin film | | |
|---|---|---|
| | Boiling point (°C) /pressure (mmHg) | Melting point (°C) |
| Sr(DPM)₂ | 213/0.1 | 210 |
| Bi(C₆H₅)₃ | 130/0.1 | 80 |
| Ta(OC₂H₅)₅ | 118/0.1 | 22 |
| THF | 67 | -109 |
| Sr(Ta(OEt)₅)₂ | 176/0.1 | 130 |
| Bi(OtAm)₃ | 87/0.1 | 90 |

An apparatus used for the MOCVD method includes a reaction section in which the SrBi₂TaO₉ thin film raw material undergoes gas phase reaction and surface reaction to form a film and a supply section in which the SrBi₂TaO₉ thin film raw material and an oxidizing agent are supplied to the reaction section.

The supply section is provided with a vaporizer for vaporizing the thin film raw material.

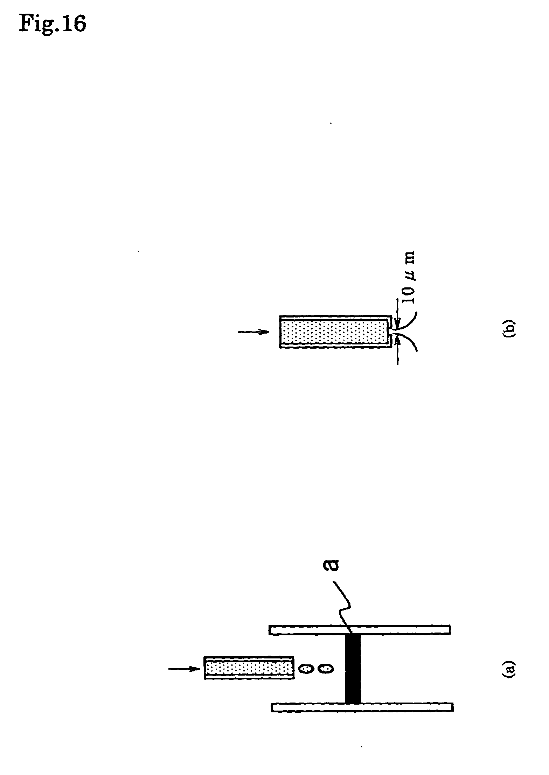

Conventionally, as a technique concerning the vaporizer, methods shown in Figure 16 has been known. The method shown in Figure 16(a), which is called a metal filter method, is a method in which vaporization is accomplished by introducing a raw material solution heated to a predetermined temperature to a metal filter used for increasing the contact area of gas existing in the surroundings with the SrBi₂TaO₉ ferroelectric thin film raw material solution.

However, in this technique, the metal filter is clogged by vaporization for several hours, which poses a problem in that this metal filter cannot be used for a long period of time. The inventor presumed that the reason for this is that the solution is heated and a substance having a lower vaporization temperature evaporates.

Figure 16(b) shows a technique in which a raw material solution is discharged through a minute hole of 10 µm by applying a pressure of 30 kgf/cm² to the raw material solution, by which the raw material solution is vaporized by expansion.

However, in this technique, the minute hole is clogged by vaporization for several hours, which poses a problem in that this minute hole cannot be used for a long period of time.

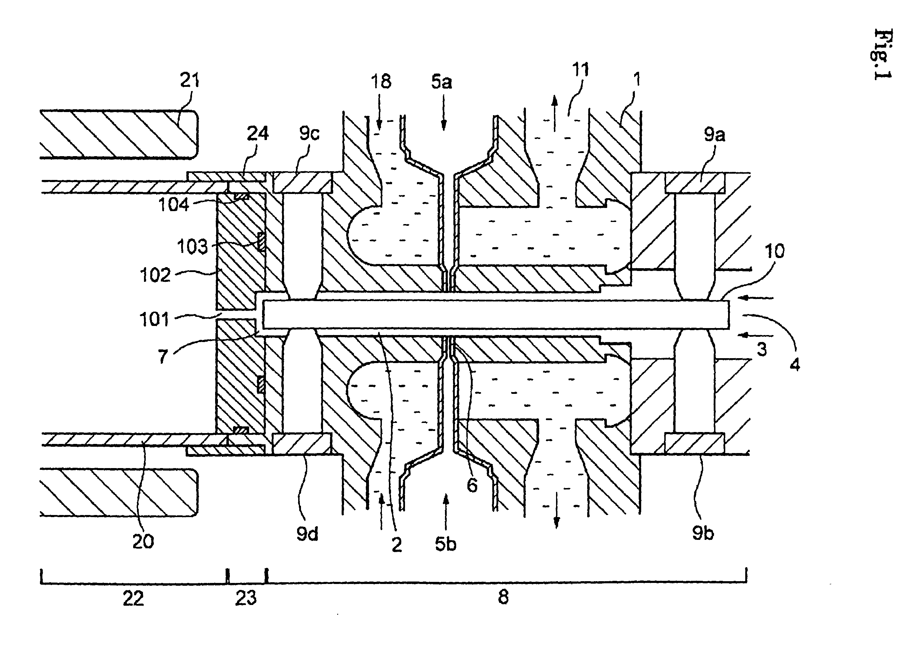

Also, in the case where the raw material solution is a mixed solution of a plurality of organic metal complexes, for example, a mixed solution of Sr(DPM)₂/THF and Bi(C₆H₅)₃/THF and Ta(OC₃H₅)₅/THF, and vaporization is accomplished by the heating of this mixed solution, a solvent having the highest vapor pressure (in this case, THF) vaporizes earliest, which poses a problem in that the raw material cannot be supplied stably because the organic metal complexes deposit on the heated surface. In all methods shown in Figure 1, the quantity of heat capable of evaporating or changing the solvent is added in a liquid or mist state.

Furthermore, in the MOCVD, in order to obtain a film with high homogeneity, it is requested to obtain vaporized gas in which the raw material solution disperses homogeneously. However, the above-described conventional techniques do not necessarily meet the request.

To meet the above-described request, the inventor has separately provided a technique described below.

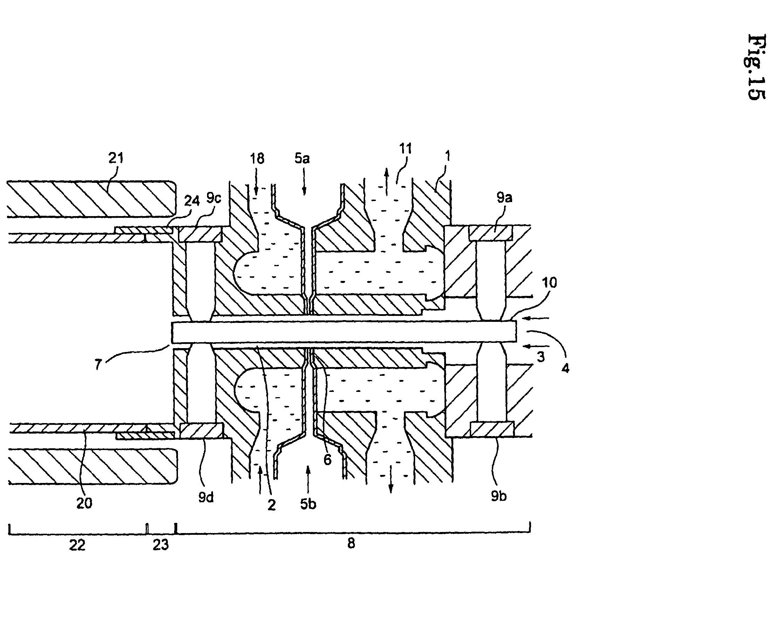

Specifically, as shown in Figure 15, there has been provided a vaporizer for MOCVD including:
(1) a dispersion section having a gas passage formed in the interior, a gas introduction port for introducing a pressurized carrier gas to the gas passage, means for supplying a raw material solution to the gas passage, a gas outlet for sending the carrier gas containing the raw material solution to a vaporization section, means for cooling the gas passage, and a radiation heat preventive blowoff portion cooled so that thermal energy is not applied to the raw material gas in the dispersion section by radiation heat from the vaporization section; and
(2) a vaporization section for heating and vaporizing the carrier gas containing the raw material solution sent from the dispersion section, having a vaporization tube one end of which is connected to a reaction tube of an MOCVD apparatus and the other end of which is connected to the gas outlet, and heating means for heating the vaporization tube; and a radiation heat preventive blowoff portion cooled so that thermal energy is not applied to the raw material gas in the dispersion section by radiation heat from the vaporization section.

This technique provides a vaporizer for MOCVD that is clogged far less than the conventional example so that it can be used for a long period of time, and can supply a raw material stably to the reaction section.

Also, in this technique, an introduction port of oxygen heated beforehand is provided on the downstream side of the vaporization section.

However, in this technique as well, deposition of crystals is found in the gas passage, so that clogging still occurs in some cases.

Also, a large quantity of carbon (30 to 40 at%) is contained in the formed film. In order to remove this carbon, annealing (for example, 800°C, 60 minutes, oxygen atmosphere) must be performed at a high temperature after film formation.

Furthermore, in the case where film formation is accomplished, there occur large variations in percentage composition.

An object of the present invention is to provide a vaporizer which can restrain the occurrence of air bubbles and can be expected to restrain variations in thin film deposit rate caused by the air bubbles, and a vaporizing method.

### DISCLOSURE OF THE INVENTION

The present invention provides a vaporizer including:
(1) a dispersion section having
   a gas passage formed in the interior,
   a gas introduction port for introducing a carrier gas into the gas passage,
   means for supplying a raw material solution to the gas passage,
   a gas outlet for sending the carrier gas containing the raw material solution to a vaporization section, and
   means for cooling the gas passage; and
(2) the vaporization section for heating and vaporizing the carrier gas containing the atomized raw material solution, which is sent from the dispersion section, having
   a vaporization tube one end of which is connected to a reaction section of film forming apparatus or other various types of apparatuses and the other end of which is connected to the gas outlet, and
   heating means for heating the vaporization tube, characterized in that
   the pressure of the reaction section is set lower than the pressure of the vaporization tube.

The film forming apparatus is preferably a normal-pressure CVD apparatus in which the pressure of the reaction section is controlled to 900 to 760 Torr.

The film forming apparatus is preferably a depressurized CVD apparatus in which the pressure of the reaction section is controlled to 20 to 0.1 Torr.

The film forming apparatus is preferably a low-pressure CVD apparatus in which the pressure of the reaction section is controlled to 0.1 to 0.001 Torr.

The present invention provides a vaporizer including:
(1) a dispersion section having
   a gas passage formed in the interior,
   a gas introduction port for introducing a carrier gas into the gas passage,
   means for supplying a raw material solution to the gas passage,
   a gas outlet for sending the carrier gas containing the raw material solution to a vaporization section, and
   means for cooling the gas passage; and
(2) the vaporization section for heating and vaporizing the carrier gas containing the raw material solution, which is sent from the dispersion section, having
   a vaporization tube one end of which is connected to a reaction section of film forming apparatus or other various types of apparatuses and the other end of which is connected to the gas outlet, and
   heating means for heating the vaporization tube, characterized in that
(3) the dispersion section has a dispersion section body having a cylindrical or conical hollow portion and a rod having an outside diameter smaller than the inside diameter of the cylindrical or conical hollow portion,
   the rod has one or two or more spiral grooves on the vaporizer side at the outer periphery of the rod, and is inserted in the cylindrical or conical hollow portion, the inside diameter thereof sometimes spreading in a taper shape toward the vaporizer side, and
   the pressure of the reaction section is set lower than the pressure of the vaporization tube.

The film forming apparatus is preferably a normal-pressure CVD apparatus in which the pressure of the reaction section is controlled to 900 to 760 Torr.

The film forming apparatus is preferably a depressurized CVD apparatus in which the pressure of the reaction section is controlled to 20 to 0.1 Torr.

The film forming apparatus is preferably a low-pressure CVD apparatus in which the pressure of the reaction section is controlled to 0.1 to 0.001 Torr.

The present invention provides a vaporizer including:
(1) a dispersion section having
   a gas passage formed in the interior,
   a gas introduction port for introducing a carrier gas into the gas passage,
   means for supplying a raw material solution to the gas passage,
   a gas outlet for sending the carrier gas containing the raw material solution to a vaporization section, and
   means for cooling the gas passage; and
(2) the vaporization section for heating and vaporizing the carrier gas containing the raw material solution, which is sent from the dispersion section, having
   a vaporization tube one end of which is connected to a reaction section of film forming apparatus or other various types of apparatuses and the other end of which is connected to the gas outlet, and
   heating means for heating the vaporization tube, characterized in that
   an oxidizing gas can be added to the carrier gas from the gas introduction port or an oxidizing gas can be introduced from a primary oxygen supply port, and
   the pressure of the reaction section is set lower than the pressure of the vaporization tube.

The film forming apparatus is preferably a normal-pressure CVD apparatus in which the pressure of the reaction section is controlled to 900 to 760 Torr.

The film forming apparatus is preferably a depressurized CVD apparatus in which the pressure of the reaction section is controlled to 20 to 0.1 Torr.

The film forming apparatus is preferably a low-pressure CVD apparatus in which the pressure of the reaction section is controlled to 0.1 to 0.001 Torr.

The present invention provides a vaporizer including:
(1) a dispersion section having
   a gas passage formed in the interior,
   a gas introduction port for introducing a carrier gas into the gas passage,
   means for supplying a raw material solution to the gas passage,
   a gas outlet for sending the carrier gas containing the raw material solution to a vaporization section, and
   means for cooling the gas passage; and
(2) the vaporization section for heating and vaporizing the carrier gas containing the raw material solution, which is sent from the dispersion section, having
   a vaporization tube one end of which is connected to a reaction section of film forming apparatus or other various types of apparatuses and the other end of which is connected to the gas outlet, and
   heating means for heating the vaporization tube, characterized in that
   a radiation preventive portion having a minute hole is provided on the outside of the gas outlet,
   the carrier gas and an oxidizing gas can be introduced from the gas introduction port, and
   the pressure of the reaction section is set lower than the pressure of the vaporization tube.
   The film forming apparatus is preferably a normal-pressure CVD apparatus in which the pressure of the reaction section is controlled to 900 to 760 Torr.

The film forming apparatus is preferably a depressurized CVD apparatus in which the pressure of the reaction section is controlled to 20 to 0.1 Torr.

The film forming apparatus is preferably a low-pressure CVD apparatus in which the pressure of the reaction section is controlled to 0.1 to 0.001 Torr.

The present invention provides a vaporizer including:
a disperser formed with
a plurality of solution passages for supplying a plurality of raw material solutions,
a mixing section for mixing the raw material solutions supplied from the solution passages,
a supply passage one end of which communicates with the mixing section and which has an outlet on the vaporization section side,
a gas passage arranged so that a carrier gas or a mixed gas of the carrier gas and oxygen is blown to the mixed raw material solution coming from the mixing section in the supply passage, and
cooling means for cooling the supply passage; and
a vaporization section for heating and vaporizing the carrier gas containing the raw material solutions, which is sent from the disperser, having
a vaporization tube one end of which is connected to a reaction section of a film forming apparatus or other various types of apparatuses and the other end of which is connected to the outlet of the disperser, and
heating means for heating the vaporization tube, characterized in that
a radiation preventive portion having a minute hole is provided on the outside of the outlet,
a primary oxygen supply port capable of introducing an oxidizing gas is provided just near the dispersion blowoff portion, and
the pressure of the reaction section is set lower than the pressure of the vaporization tube.

The film forming apparatus is preferably a normal-pressure CVD apparatus in which the pressure of the reaction section is controlled to 900 to 760 Torr.

The film forming apparatus is preferably a depressurized CVD apparatus in which the pressure of the reaction section is controlled to 20 to 0.1 Torr.

The film forming apparatus is preferably a low-pressure CVD apparatus in which the pressure of the reaction section is controlled to 0.1 to 0.001 Torr.

The present invention provides a film forming apparatus including the vaporizer as described above.

The present invention provides a vaporizing method in which a raw material solution is introduced into a gas passage, and a carrier gas is sprayed toward the introduced raw material solution, by which the raw material solution is sheared and atomized into raw material mist, and then, the raw material mist is supplied to a vaporization section to be vaporized, characterized in that
control is carried out so that the pressures of the carrier gas and the introduced raw material solution are almost equal in a region in which the carrier gas comes into contact with the introduced raw material solution.

The present invention provides a vaporizing method in which a raw material solution is introduced into a gas passage, and a carrier gas is sprayed toward the introduced raw material solution, by which the raw material solution is sheared and atomized into raw material mist, and then, the raw material mist is supplied to a vaporization section to be vaporized, characterized in that
control is carried out so that the pressure of the carrier gas is lower than the pressure of the introduced raw material solution in a region in which the carrier gas comes into contact with the introduced raw material solution.

Control is preferably carried out so that the pressure of the carrier gas is lower than the pressure of the introduced raw material solution by 760 Torr at a maximum in a region in which the carrier gas comes into contact with the introduced raw material solution.

Control is preferably carried out so that the pressure of the carrier gas is lower than the pressure of the introduced raw material solution by 100 to 10 Torr at a maximum in a region in which the carrier gas comes into contact with the introduced raw material solution.

The present invention provides a vaporizing method in which a raw material solution is introduced into a gas passage, and a carrier gas is sprayed toward the introduced raw material solution, by which the raw material solution is sheared and atomized into raw material mist, and then, the raw material mist is supplied to a vaporization section to be vaporized, characterized in that
control is carried out so that the pressures of the carrier gas and the raw material solution are higher than the vapor pressure of the introduced raw material solution in a region in which the carrier gas comes into contact with the introduced raw material solution.

In a vaporizing method in which a raw material solution is introduced into a gas passage, and a carrier gas is sprayed toward the introduced raw material solution, by which the raw material solution is sheared and atomized into raw material mist, and then, the raw material mist is supplied to a vaporization section to be vaporized,
control is preferably carried out so that the pressures of the carrier gas and the raw material solution are 1.5 times or more higher than the vapor pressure of the introduced raw material solution in a region in which the carrier gas comes into contact with the introduced raw material solution.

Oxygen is preferably contained in the carrier gas in advance.

The present invention provides a film characterized by being formed after vaporization is accomplished by the vaporizing method as described above.

The present invention provides an electronic device including the above-described film.

The present invention provides a CVD thin film forming method characterized in that after a pressurizing gas dissolved in a transfer solution using the pressurizing gas has been removed, the flow rate is controlled, and the vaporizer is connected to a CVD apparatus to form a thin film.

It is preferable that the transfer solution using the pressurizing gas be caused to flow in a fluororesin pipe in which transmission speed is controlled, whereby only the pressurizing gas be removed.

It is preferable that when only the pressurizing gas is removed by causing the transfer solution using the pressurizing gas to flow in a fluororesin pipe etc. in which transmission speed is controlled, the removal of the pressuring gas be accelerated by controlling the external environment of the fluororesin pipe etc.

The present invention provides a vaporizing method in which a raw material solution is introduced into a passage and introduced into a depressurized and heated vaporizer, and is sprayed or dripped into the vaporizer, whereby the raw material solution is atomized and vaporized, characterized in that control is carried out so that the pressure of the raw material solution in the tip end portion of the passage is higher than the vapor pressure of the introduced raw material solution.

Control is preferably carried out so that the pressure of the raw material solution is 1.5 times or more the vapor pressure of the introduced raw material solution in the tip end portion of the passage.

The present invention provides a vaporizing method in which a raw material solution and a carrier gas are introduced into a depressurized and heated vaporizer, and are sprayed into the vaporizer, whereby the raw material solution is atomized and vaporized, characterized in that control is carried out so that the pressure of the raw material solution in the tip end portion of the passage is higher than the vapor pressure of the introduced raw material solution.

Control is preferably carried out so that the pressure of the raw material solution is 1.5 times or more the vapor pressure of the raw material solution in the tip end portion of the passage.

Oxygen is preferably contained in the carrier gas in advance.

Control is preferably carried out so that the pressures of the carrier gas and the introduced raw material solution are almost equal in a region in which the carrier gas comes into contact with the introduced raw material solution.

Control is preferably carried out so that the pressure of the carrier gas is lower than the pressure of the introduced raw material solution in a region in which the carrier gas comes into contact with the introduced raw material solution.

Control is preferably carried out so that the pressure of the carrier gas is lower than the pressure of the introduced raw material solution by 760 Torr at a maximum in a region in which the carrier gas comes into contact with the introduced raw material solution.

Control is preferably carried out so that the pressure of the carrier gas is lower than the pressure of the introduced raw material solution by 100 to 10 Torr at a maximum in a region in which the carrier gas comes into contact with the introduced raw material solution.

Control is preferably carried out so that the pressures of the carrier gas and the raw material solution are higher than the vapor pressure of the introduced raw material solution in a region in which the carrier gas comes into contact with the introduced raw material solution.

Control is preferably carried out so that the pressures of the carrier gas and the raw material solution are 1.5 times or more higher than the vapor pressure of the introduced raw material solution in a region in which the carrier gas comes into contact with the introduced raw material solution.

The present invention provides a CVD thin film forming apparatus in which a transfer solution using a pressurizing gas is introduced into the vaporizer via a mass-flow controller, and the vaporizer is connected to the CVD apparatus, whereby a thin film is formed, characterized in that degassing means for removing a pressuring gas is provided on the upstream side of the mass-flow controller.

Also, the present invention is applicable to the following vaporizers and vaporizing methods:
A vaporizer including:
   (1) a dispersion section having
      a gas passage formed in the interior,
      a gas introduction port for introducing a carrier gas into the gas passage,
      means for supplying a raw material solution to the gas passage,
      a gas outlet for sending the carrier gas containing the raw material solution to a vaporization section, and
      means for cooling the gas passage; and
   (2) the vaporization section for heating and vaporizing the carrier gas containing the atomized raw material solution, which is sent from the dispersion section, having
      a vaporization tube one end of which is connected to a reaction section of film forming apparatus or other various
      types of apparatuses and the other end of which is connected to the gas outlet, and
      heating means for heating the vaporization tube, characterized in that
      a radiation preventive portion having a minute hole is provided on the outside of the gas outlet.
A vaporizer including:
   (1) a dispersion section having
      a gas passage formed in the interior,
      a gas introduction port for introducing a carrier gas into the gas passage,
      means for supplying a raw material solution to the gas passage, and
      a gas outlet for sending the carrier gas containing the raw material solution to a vaporization section, and
   (2) the vaporization section for heating and vaporizing the carrier gas containing the raw material solution, which is sent from the dispersion section, having
      a vaporization tube one end of which is connected to a reaction section of film forming apparatus or other various types of apparatuses and the other end of which is connected to the gas outlet, and
      heating means for heating the vaporization tube, characterized in that
   (3) the dispersion section has a dispersion section body having a cylindrical or conical hollow portion and a rod having an outside diameter smaller than the inside diameter of the cylindrical or conical hollow portion,
      the rod has one or two or more spiral grooves on the vaporizer side at the outer periphery of the rod, and is inserted in the cylindrical or conical hollow portion, and
   (4) a cooled radiation preventive portion is provided which has a minute hole on the gas outlet side on the outside of the gas outlet and the inside diameter of which spreads in a taper shape toward the vaporizer.
A vaporizer including:
   (1) a dispersion section having
      a gas passage formed in the interior,
      a gas introduction port for introducing a carrier gas into the gas passage,
      means for supplying a raw material solution to the gas passage,
      a gas outlet for sending the carrier gas containing the raw material solution to a vaporization section, and
      means for cooling the gas passage; and
   (2) the vaporization section for heating and vaporizing the carrier gas containing the atomized raw material solution, which is sent from the dispersion section, having
      a vaporization tube one end of which is connected to a reaction section of film forming apparatus or other various types of apparatuses and the other end of which is connected to the gas outlet, and
      heating means for heating the vaporization tube, characterized in that
      a small quantity of oxidizing gas can be added to the carrier gas such as Ar, N₂ or helium from the gas introduction port or an oxidizing gas or the mixed gas thereof can be introduced from a primary oxygen supply port just near a blowoff portion.
A vaporizer including:
   (1) a dispersion section having
      a gas passage formed in the interior,
      a gas introduction port for introducing a carrier gas into the gas passage,
      means for supplying a raw material solution to the gas passage,
      a gas outlet for sending the carrier gas containing the raw material solution to a vaporization section, and
      means for cooling the gas passage; and
   (2) the vaporization section for heating and vaporizing the carrier gas containing the raw material solution, which is sent from the dispersion section, characterized in that
      a radiation preventive portion having a minute hole is provided on the outside of the gas outlet, and
      the carrier gas and an oxidizing gas can be introduced from the gas introduction port.

A vaporizing method in which a raw material solution is introduced into a gas passage, and a carrier gas with a high velocity is sprayed toward the introduced raw material solution, by which the raw material solution is sheared and atomized into raw material gas, and then, the raw material gas is supplied to a vaporization section to be vaporized, characterized in that oxygen is contained in the carrier gas in advance.

A vaporizing method using a vaporizer formed with
a plurality of solution passages for supplying raw material solutions,
a mixing section for mixing the raw material solutions supplied from the solution passages,
a supply passage one end of which communicates with the mixing section and which has an outlet on the vaporization section side,
a gas passage arranged so that a carrier gas or a mixed gas of the carrier gas and oxygen is blown to the mixed raw material solution coming from the mixing section in the supply passage, and
cooling means for cooling the supply passage.

### BRIEF DESCRIPTION OF THE DRAWINGS

Figure 1 is a sectional view showing a principal portion of a vaporizer for MOCVD in accordance with example 1;
Figure 2 is a general sectional view of a vaporizer for MOCVD in accordance with example 1;
Figure 3 is a system diagram of MOCVD;
Figure 4 is a front view of a reserve tank;
Figure 5 is a sectional view showing a principal portion of a vaporizer for MOCVD in accordance with example 2;
Figure 6 is a sectional view showing a principal portion of a vaporizer for MOCVD in accordance with example 3;
Figures 7(a) and 7(b) are sectional views showing modifications of a gas passage of a vaporizer for MOCVD in accordance with example 4;
Figure 8 is a sectional view showing a principal portion of a vaporizer for MOCVD in accordance with example 5;
Figure 9 is a view of a rod used for the vaporizer for MOCVD in accordance with example 5, Figure 9(a) being a side view, Figure 9(b) being a sectional view taken along the line X-X, and Figure 9(c) being a sectional view taken along the line Y-Y;
Figure 10 is a side view showing a modification of Figure 9(a);
Figure 11 is a graph showing an experimental result in example 6;
Figure 12 is a side sectional view showing example 8;
Figure 13 is a schematic diagram showing a gas supply system of example 8;
Figure 14 is a side sectional view showing example 9;
Figure 15 is a sectional view showing the latest conventional technique;
Figures 16(a) and 16(b) are sectional views of a conventional vaporizer for MOCVD;
Figure 17 is a graph showing a crystallization characteristic of an SBT thin film;
Figure 18 is a graph showing a polarization characteristic of a crystallized SBT thin film;
Figure 19 is a detailed view of a vaporizer;
Figure 20 is a general view of a vaporizer;
Figure 21 is a view showing an example of an SBT thin film CVD apparatus using a vaporizer;
Figure 22 is a sectional view showing an example of a film forming apparatus;
Figure 23 is a view showing a construction for heating medium circulation shown in Figure 22;
Figure 24 is a view of a degassing system;
Figure 25 is a view showing an example of degassing method;
Figure 26 is a view showing an example of degassing method;
Figure 27 is a graph showing dependency of air bubble occurrence on residence time and pressure;
Figure 28 is a view of an air bubble evaluation vaporizer;
Figure 29 is a view showing behavior of air bubbles; and
Figure 30 is a view showing various types of vaporizers.

### [Explanation of reference numerals]

Figure 2
   a: FILM FORMING APPARATUS
   b: COOLING WATER
Figure 3
   a: RECOVERY SECTION
   b: REACTION SECTION
   c: SUPPLY SECTION
   d: EXHAUST GAS
   e: VAPORIZER
   f: MASS-FLOW CONTROLLER
   g: OXYGEN
   h: HEATED SECTION
Figure 4
   a: RAW MATERIAL SOLUTION
   b: ARGON
Figure 7
   a: GAS PASSAGE
Figure 12
   a: MOCVD APPARATUS
   b: COOLING WATER
Figure 13
   a: RECOVERY SECTION
   b: REACTION SECTION
   c: SUPPLY SECTION
   d: EXHAUST GAS
   e: VAPORIZER
   f: MASS-FLOW CONTROLLER
   g: OXYGEN
   h: HEATED SECTION
Figure 16
   a: METAL FILTER
Figure 19
   a: FIRST CARRIER
   b: RAW MATERIAL SOURCE INTRODUCING ORIFICE
   c: COOLING WATER
   d: SECOND MIXING SECTION & ATOMIZING NOZZLE PORTION
   e: SECOND CARRER
   f: FIRST MIXING SECTION
Figure 20
   a: SHEATH HEATER
   b: PERMA
   c: HEAT EXCHANGER
   d: VAPORIZATION SECTION PROPER DISTANCE AND TEMPERATURE
   e: MANTLE HEATER
   f: VAPORIZATION HEAD
   g: CONTROLLER
   h: PRESSURE GAGE
   i: VAPORIZATION SECTION AUTOMATIC PRESSURE REGULATING VALVE
   j: THERMOCOUPLE
   k: O₂ OR AIR (SWITCHING OVER)
   l: INTRODUCED GAS (SWIRL MIXING)
   m: HORIZONTAL SECTIONAL VIEW (GAS FLOW IMAGE)
   n: THERMOCOUPLE
   o: SHOWER HEAD
   p: HOT WALL CHAMBER
Figure 21
   a: DEGASSING SYSTEM
   b: N₂, Ar OR He
   c: HEAT EXCHANGER
   d: SUBSTRATE (4" TO 8")
   e: LOAD LOCK CHAMBER
   f: WAFER CONVEYING MECHANISM
   g: LOADER
   h: GATE VALVE
   i: EXHAUST GAS
   j: VAPORIZER
   k: PROCESS CHAMBER
Figure 24
   a: PRESSURIZED GAS
   b: PRESSURE GAGE
   c: CONTAINER HEXANE (5 LITERS)
   d: DEGASSING METHOD (A, B, C, D, E)
   e: LIQUID MASS-FLOW CONTROLLER
   f: OCCURRENCE OF AIR BUBBLES WAS CHECKED AT OUTLET OF LIQUID MASS-FLOW CONTROLLER
   g: GLASS CONTAINER
   h: PUMP
   i: EXHAUST GAS
Figure 25
   A: PFA TUBE BEING HELD IN AIR (LENGTH OF 1/8" PFA TUBE WAS CHANGED)
   a: LENGTH: 15 TO 120 cm
   B: USE OF DEPRESSURIZING SYSTEM OF OWN MAKING (1/8" PFA TUBE WAS USED)
   b: LENGTH: 120 cm
   c: LENGTH IN DEPRESSURIZING SYSTEM: 200 cm, 800 cm
   d: PRESSURE IN SYSTEM: 0.1 Torr
Figure 26
   C: POLYIMIDE TUBE BEING HELD IN AIR
   a: LENGTH: 131 cm
   D: USE OF DEPRESSURIZING SYSTEM OF OWN MAKING (POLYIMIDE TUBE WAS USED)
   b: LENGTH: 131 cm
   c: LENGTH IN DEPRESSURIZING SYSTEM: 140 cm
   d: PRESSURE IN SYSTEM: 0.1 Torr
   E: COMMERCIALLY AVAILABLE DEGASSING SYSTEM (MANUFACTURED BY YOKOHAMA RIKA Co.,Ltd.)
   e: 1/8" O.D. PFA TUBE 120 cm
   f: DEGASSING SYSTEM
   g: DEPRESSURIZATION: MAKER SPECIFICATION (FOR LIQUID CHROMATOGRAPHY)
Figure 27
   a: LINE OUTLET PRESSURE (Torr)
   b: REGIDENCE TIME (min)
   c: AIR BUBBLE NON-OCCURRENCE REGION
   d: AIR BUBBLE OCCURRENCE REGION
   e: LOWER LIMIT PRESSURE AT WHICH AIR BUBBLES WERE NOT CONFIRMED
   f: UPPER LIMIT PRESSURE AT WHICH AIR BUBBLES WERE CONFIRMED
   g: 1/8" PFA TUBE BEING USED (O.D. 3.2 mm, I.D. 1.32 mm)
Figure 28
   a: FIRST CARRIER
   b: SECOND CARRIER
Figure 29
   a: EVAPORATION HEAD
Figure 30
   a: PERMEATION TYPE
   b: CARRIER
   c: HEATER
   d: LIQUID
   e: DRIP TYPE
   f: PRESSURIZED SEEPAGE TYPE
   g: DIAPHRAGM TYPE
   h: PRESSURIZED BLOWOFF TYPE

- 1: dispersion section body
- 2: gas passage
- 3: carrier gas
- 4: gas introduction port
- 5: raw material solution
- 6: raw material supply hole
- 7: gas outlet
- 8: dispersion section
- 9a, 9b, 9c,: machine screw
- 10: rod
- 18: means for cooling (cooling water)
- 20: vaporization tube
- 21: heating means (heater)
- 22: vaporization section
- 23: connecting portion
- 24: joint
- 25: oxygen introducing means (primary oxygen (oxidizing gas) supply port)
- 29: raw material supply inlet
- 30a, 30b, 30c, 30d: mass-flow controller
- 31a, 31b, 31c, 31d: valve
- 32a, 32b, 32c, 32d: reserve tank
- 33: carrier gas bomb
- 42: exhaust outlet
- 40: valve
- 44: reaction tube
- 46: gas pack
- 51: taper
- 70: groove
- 101: minute hole
- 102: radiation preventive portion
- 107: OUTLET
- 109: MIXING SECTION
- 110: SUPPLY PASSAGE
- 120: GAS PASSAGE
- 150: DISPERSER
- 200: oxygen introducing means (secondary oxygen (oxidizing gas), carrier supply port)
- 301: upstream ring
- 302: downstream ring
- 303a, 303b: heat transfer path
- 304: heat conversion plate
- 304a: gas vent hole gas nozzle
- 306: exhaust outlet
- 308: orifice
- 312: substrate heater
- 320: heating medium inlet
- 321: heating medium outlet
- 390: heat input medium
- 391: heat output medium
- 3100: silicon substrate

### BEST MODE FOR CARRYING OUT THE INVENTION

### [Example 1]

Figure 1 shows a vaporizer for MOCVD in accordance with example 1.

In this example, the vaporizer includes:
a dispersion section 8 having a gas passage 2 formed in a dispersion section body 1 forming a dispersion section,
a gas introduction port 4 for introducing a pressurized carrier gas 3 to the gas passage 2,
means (raw material supply hole) 6 for supplying a raw material solution 5 to the carrier gas passing through the gas passage 2 and for making the raw material solution 5 in a mist form,
a gas outlet 7 for sending the carrier gas (raw material gas) containing the mist-form raw material solution 5 to a vaporization section 22, and
means (cooling water) 18 for cooling the carrier gas flowing in the gas passage 2; and
the vaporization section 22 for heating and vaporizing the carrier gas in which the raw material solution is dispersed, which is sent from the dispersion section 8, having
a vaporization tube 20 one end of which is connected to a reaction tube of an MOCVD apparatus and the other end of which is connected to the gas outlet 7 of the dispersion section 8, and
heating means (heater) 21 for heating the vaporization tube 20, and
a radiation preventive portion 102 having a minute hole 101 is provided on the outside of the gas outlet 7.

Next, this example is explained in more detail.

In the example shown in Figure 1, the interior of the dispersion section body 1 is a cylindrical hollow portion. A rod 10 is inserted in the hollow portion, and the gas passage 2 is formed by the internal wall of the dispersion section body and the rod 10. The hollow portion is not limited to the cylindrical shape, and may take any other shapes. For example, a conical shape is preferable. The conical angle of the conical hollow portion is preferably 0 to 45°, more preferably 8 to 20°. The same is true in other examples.

The cross sectional area of the gas passage is preferably 0.10 to 0.5 mm². If it is less than 0.10 mm², the fabrication is difficult to do. If it exceeds 0.5 mm², it is necessary to use a high-pressure carrier gas with a high flow rate to speed up the carrier gas.

If the carrier gas with a high flow rate is used, a high-capacity large vacuum pump is needed to keep a reaction chamber in a depressurized state (for example, 1.0 Torr). Since it is difficult to use a vacuum pump having an evacuation capacity exceeding 10,000 liters/min (at 1.0 Torr), in order to achieve industrially practical application, a proper flow rate, i.e., a gas passage area of 0.10 to 0.5 mm² is preferable.

At one end of this gas passage 2, the gas introduction port 4 is provided. The gas introduction port 4 is connected with a carrier gas (for example, N₂, Ar, He) source (not shown).

At the side of a substantially central portion of the dispersion section body 1, the raw material supply hole 6 is provided so as to communicate with the gas passage 2, so that the raw material solution 5 is introduced into the gas passage 2, and thus the raw material solution 5 can be dispersed in the carrier gas passing through the gas passage 2 to form the raw material gas.

At one end of the gas passage 2, the gas outlet 7 communicating with the vaporization tube 20 of the vaporization section 22 is provided.

In the dispersion section body 1, a space 11 for causing the cooling water 18 to flow is formed. By causing the cooling water 8 to flow in this space, the carrier gas flowing in the gas passage 2 is cooled. Alternatively, in place of this space, a Peltier element etc. may be provided to cool the carrier gas. Since the interior of the gas passage 2 of the dispersion section 8 is thermally affected by the heater 21 of the vaporization section 22, a solvent and an organic metal complex of the raw material solution do not vaporize at the same time in the gas passage 2, and only the solvent vaporizes. Therefore, by cooling the carrier gas in which the raw material solution is dispersed, flowing in the gas passage 2, vaporization of only the solvent is prevented. In particular, the cooling on the downstream side of the raw material supply hole 6 is important, and therefore at least a portion on the downstream side of the raw material supply hole 6 is cooled. The cooling temperature is a temperature equal to or lower than the boiling point of solvent. For example, in the case of THF, the cooling temperature is 67°C or lower. In particular, the temperature at the gas outlet 7 is important.

In this example, the radiation preventive portion 102 having the minute hole 101 is further provided on the outside of the gas outlet 7. Reference numerals 103 and 104 denote sealing members such as O-rings. This radiation preventive portion 102 can be formed of Teflon (registered trade name), stainless steel, ceramics, or the like. Also, the radiation preventive portion 102 is preferably formed of a material having high thermal conductivity.

According to the knowledge of the inventor, in the conventional technique, the heat in the vaporization section overheats the gas in the gas passage 2 via the gas outlet 7 as radiation heat. Therefore, even if the gas is cooled by the cooling water 18, a low melting point component in the gas deposits near the gas outlet 7.

The radiation preventive portion is a member for preventing the radiation heat from propagating to the gas. Therefore, the cross-sectional area of the minute hole 101 is preferably smaller than the cross-sectional area of the gas passage 2. It is preferably equal to or less than 1/2, more preferably equal to or less than 1/3 of the cross-sectional area of the gas passage 2. Also, the minute hole is preferably miniaturized. In particular, it is preferably miniaturized to a size such that the flow velocity of emitting gas is subsonic.

Also, the length of the minute hole is preferably equal to or more than five times, more preferably equal to or more than ten times the minute hole size.

Also, by cooling the dispersion section, blockage due to carbide in the gas passage (especially the gas outlet) is prevented even if the vaporizer is used for a long period of time.

On the downstream side of the dispersion section body 1, the dispersion section body 1 is connected to the vaporization tube 20. The connection between the dispersion section body 1 and the vaporization tube 20 is made by a joint 24, and this portion serves as a connecting portion 23.

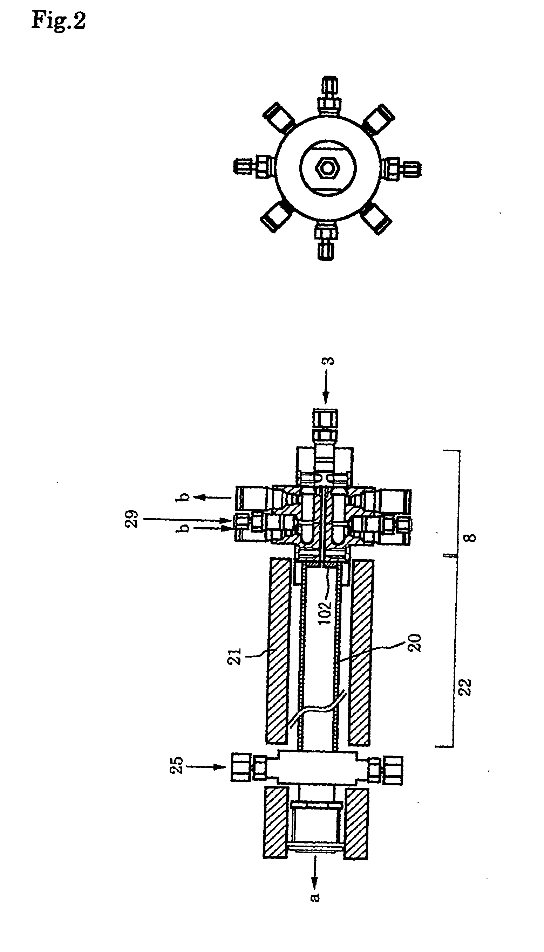

Figure 2 is a general view. The vaporization section 22 includes the vaporization tube 20 and the heating means (heater) 21. The heater 21 is a heater for heating and vaporizing the carrier gas in which the raw material solution is dispersed, flowing in the vaporization tube 20. The heater 21 has conventionally been formed by affixing a cylindrical heater or a mantle heater at the outer periphery of the vaporization tube 20. However, in order to heat the vaporization tube 20 so that a uniform temperature is achieved in the lengthwise direction of the vaporization tube, a method in which a liquid or a gas having high heat capacity is used as a heating medium is most excellent. Therefore, this method was used in this example.

As the vaporization tube 20, stainless steel, for example, SUS316L is preferably used. The dimensions of the vaporization tube 20 may be determined appropriately so that its length is enough to heat the vaporized gas. For example, when a SrBi₂Ta₂O₉ raw material solution of 0.04 ccm is vaporized, the vaporization tube 20 having an outside diameter of 3/4 inches and a length of several hundred millimeters can be used.

The downstream side end of the vaporization tube 20 is connected to a reaction tube of an MOCVD apparatus. In this example, an oxygen supply port 25 is provided on the vaporization tube 20 as oxygen supply means so that oxygen heated to a predetermined temperature can be fed to the carrier gas.

First, the supply of raw material solution to the vaporizer is described.

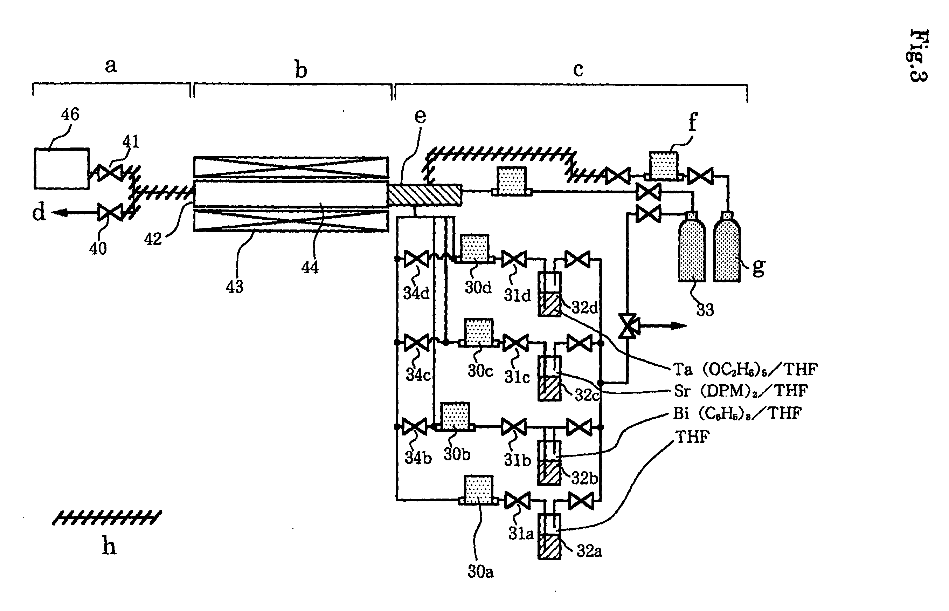

As shown in Figure 3, reserve tanks 32a, 32b, 32c and 32d are connected to the raw material supply hole 6 via mass-flow controllers 30a, 30b, 30c and 30d and valves 31a, 31b, 31c and 31d, respectively.

Also, the reserve tanks 32a, 32b, 32c and 32d are connected with a carrier gas bomb 33.

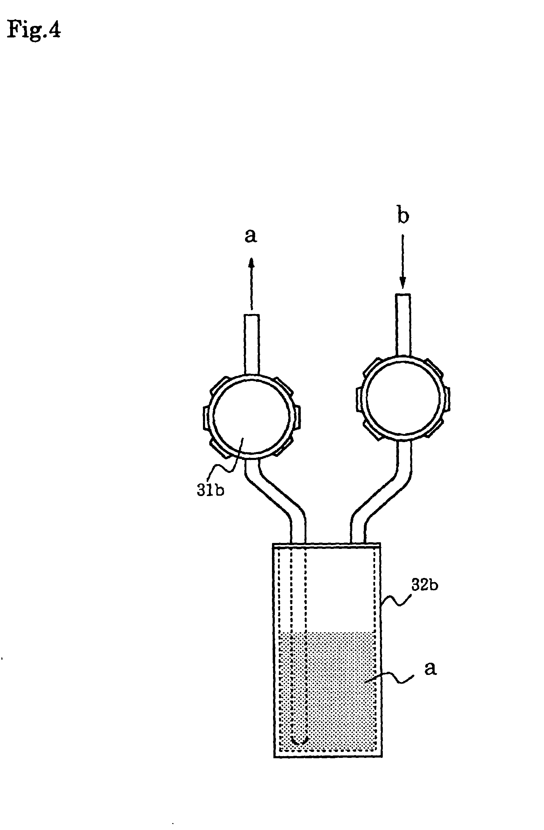

The details of the reserve tank are shown in Figure 4.

The reserve tank is filled with the raw material solution. The carrier gas (for example, inert gas Ar, He, Ne) of, for example, 1.0 to 3.0 kgf/cm² is sent into each of the reserve tank (content volume: 300 cc, made of SUS). Since the interior of the reserve tank is pressurized by the carrier gas, the raw material solution is pushed up in the tube on the side contacting with the solution, and is sent under pressure to the liquid mass-flow controller (manufactured by STEC, full-scale flow rate: 0.2 cc/min), where the flow rate is controlled. The raw material solution is conveyed to the raw material supply hole 6 through a raw material supply inlet 29 of the vaporizer.

The raw material solution, whose flow rate has been controlled to a fixed value by the mass-flow controller, is conveyed to a reaction section by the carrier gas. At the same time, oxygen (oxidizing agent), whose flow rate has been controlled to a fixed value by a mass-flow controller (manufactured by STEC, full-scale flow rate: 2 L/min), is also conveyed to the reaction section.

Since in the raw material solution, a liquid-form or solid-form organic metal complex is dissolved in THF and other solvents at ordinary temperature, if it is left as it is, the organic metal complex is deposited by the evaporation of THF solvent, and it finally becomes in a solid form. Therefore, it is assumed that the tube in contact with the raw liquid may be blocked by the deposited organic metal complex. In order to restrain the blockage of tube, a cleaning line is provided considering that the interior of the tube and vaporizer should be cleaned with THF and other solvents after the film forming work has been finished. In the cleaning operation, a portion fitting to each work including raw material container replacement work in a section from the container outlet side to the vaporizer is washed off with the solvent.

The valves 31b, 31c and 31d were opened, and the carrier gas was sent under pressure into the reserve tanks 32b, 32c and 32d. The raw material solution is sent under pressure to the mass-flow controller (manufactured by STEC, full-scale flow rate: 0.2 cc/min), where the flow rate is controlled. The raw material solution is conveyed to the raw material supply hole 6 of the vaporizer.

On the other hand, the carrier gas was introduced through the gas introduction port of the vaporizer. The maximum pressure on the supply port side is preferably equal to or lower than 3 kgf/cm². At this time, the maximum flow rate of gas capable of passing through is about 1200 cc/min, and the flow velocity in the gas passage 2 reaches one hundred and several tens meters per second.

When the raw material solution is introduced through the raw material supply hole 6 to the carrier gas flowing in the gas passage 2 of the vaporizer, the raw material solution is sheared by the high-velocity flow of carrier gas and changed to ultrafine particles. As a result, the raw material solution is dispersed in the carrier gas in an untrafine particle state. The carrier gas in which the raw material solution is dispersed in an untrafine particle state (raw material gas) is atomized as being in a high-velocity state by the vaporization section 22 and is released. The angle formed between the gas passage and the raw material supply hole is optimized. In the case where the angle between the carrier flow path and the raw material solution introduction port is an acute angle (30 degrees), the solution is drawn by the gas. If the angle is equal to or larger than 90 degrees, the solution is pushed by the gas. The optimum angle is determined from the viscosity and flow rate of solution. When the viscosity or the flow rate is high, the solution is caused to flow smoothly by making the angle more acute. In the case where hexane is used as the solvent to form an SBT film, an angle of about 84 degrees is preferable because both viscosity and flow rate are low.

Three kinds of raw material solutions, whose flow rate has been controlled to a fixed value, flow into the gas passage 2 through the raw material supply hole 6 via the raw material supply inlet 29, and after moving in the gas passage together with the carrier gas, which forms a high-velocity gas flow, they are released to the vaporization section 22. In the dispersion section 8 as well, the raw material solution is heated by the heat from the vaporization section 22, and the evaporation of THF and other solvents is accelerated. Therefore, a section from the raw material supply inlet 29 to the raw material supply hole 6 and a section of the gas passage 2 are cooled by water or other cooling media.

The vaporization of the raw material solution, which is dispersed in the carrier gas in a fine particle form, released from the dispersion section 8 is accelerated during the conveyance in the vaporization tube 20 heated to a predetermined temperature by the heater 21. By the feeding of oxygen heated to a predetermined temperature from the oxygen supply port 25 provided just before the raw material solution reaches the reaction tube of MOCVD, a mixed gas is formed, and flows into the reaction tube. In this example, evaluation was carried out by analyzing the reaction mode of vaporized gas in place of film formation.

A vacuum pump (not shown) was connected from an exhaust outlet 42 to remove water and other impurities in the reaction tube 44 by means of an evacuating operation for about 20 minutes, and a valve 40 on the downstream side of the exhaust outlet 42 was closed.

Cooling water was caused to flow in the vaporizer at a flow rate of about 400 cc/min. On the other hand, a carrier gas of 3 kgf/cm² was caused to flow at a flow rate of 495 cc/min. After the reaction tube 44 was sufficiently filled with the carrier gas, the valve 40 was opened. The temperature at the gas outlet 7 was lower than 67°C.

The interior of the vaporization tube 20 was heated to 200°C, a section from the reaction tube 44 to a gas pack 46 and the gas pack were heated to 100°C, and the interior of the reaction tube 44 was heated to 300°C to 600°C.

The interior of the reserve tank was pressurized by the carrier gas, and a predetermined liquid was caused to flow by the mass-flow controller. Sr(DPM)₂, Bi(C₆H₅)₃, Ta(OC₂H₅)₅, and THF were caused to flow at flow rates of 0.04 cc/min, 0.08 cc/min, 0.08 cc/min, and 0.2 cc/min, respectively.

After 20 minutes, a valve just in front of the gas pack 46 was opened to recover a reaction product in the gas pack 46. The reaction product was analyzed with a gas chromatograph, and it was examined whether the detected product coincides with the product in the reaction formula studied based on the reaction theory. As a result, in this example, the detected product coincided well with the product in the reaction formula studied based on the reaction theory.

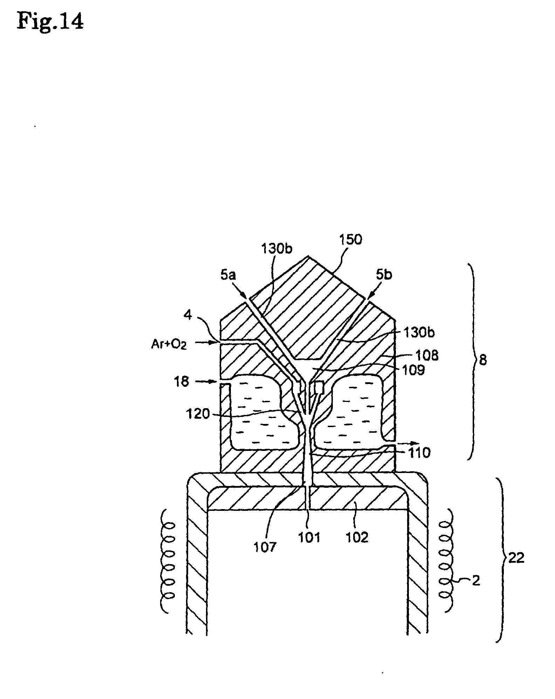

Also, the amount of carbides adhering to the external surface on the gas outlet 7 side of the dispersion section body 1 was measured. As the result, the amount of adhering carbides was very small, and was further smaller than in the case where the apparatus shown in Figure 14 was used.

In the case of a raw material solution in which a metal to be used as a film raw material is mixed with or dissolved in a solvent, the raw material solution is generally such that the metal is a complex and in a liquid/liquid state (perfect solvent solution). However, as the result of a careful examination of raw material solution conducted by the inventor, there was gained a knowledge that the metal complex is not necessarily in a scattered molecular state, and the metal complex itself is present as fine particles with a size of 1 to 100 nm in the solvent in some cases or is partially present as a solid/liquid state. It is considered that the clogging at the time of vaporization is liable to occur especially when the raw material solution is in such a state. When the evaporator in accordance with the present invention is used, clogging does not occur even when the raw material solution is in such a state.

Also, in a solution in which the raw material solution is present, the fine particles are liable to settle at the bottom by means of the gravity thereof. Therefore, to prevent clogging, it is preferable that convection be caused in the solution by heating the bottom portion (to a temperature equal to or lower than the evaporating temperature of solvent) to homogeneously disperse the fine particles. Also, it is preferable that not only the bottom portion be heated but also the side face of the container upper surface be cooled. Needless to say, the heating is performed at a temperature equal to or lower than the evaporating temperature of solvent.

It is preferable that a heater set or control the quantity of heat for heating the evaporation tube upper region so as to be larger than the quantity of heat for heating the downstream region. Specifically, since water-cooled gas blows off from the dispersion section, it is preferable that there be provided a heater that sets or controls the quantity of heat for heating so as to be large in the evaporation tube upper region and be small in the downstream region.

### [Example 2]

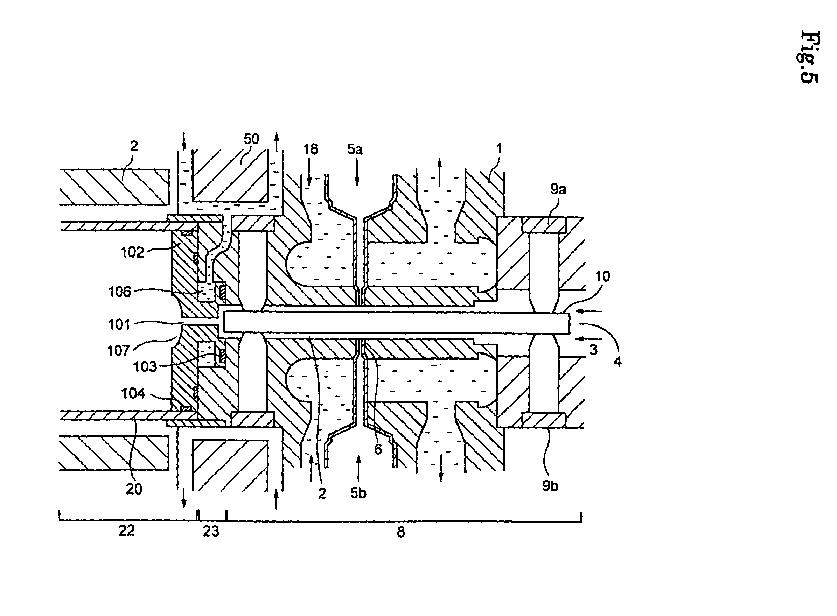

Figure 5 shows a vaporizer for MOCVD in accordance with example 2.

In this example, a cooling water passage 106 was formed at the outer periphery of the radiation preventive portion 102, and cooling means 50 was provided at the outer periphery of the connecting portion 23 to cool the radiation preventive portion 102.

Also, a concave portion 107 was provided around the outlet of the minute hole 101.

Other points are the same as in example 1.

In this example, the detected product coincided better with the product in the reaction formula studied based on the reaction theory than in the case of example 1.

Also, the amount of carbides adhering to the external surface on the gas outlet 7 side of the dispersion section body 1 was measured, with the result that the amount of adhering carbides was about 1/3 of the case of example 1.

### [Example 3]

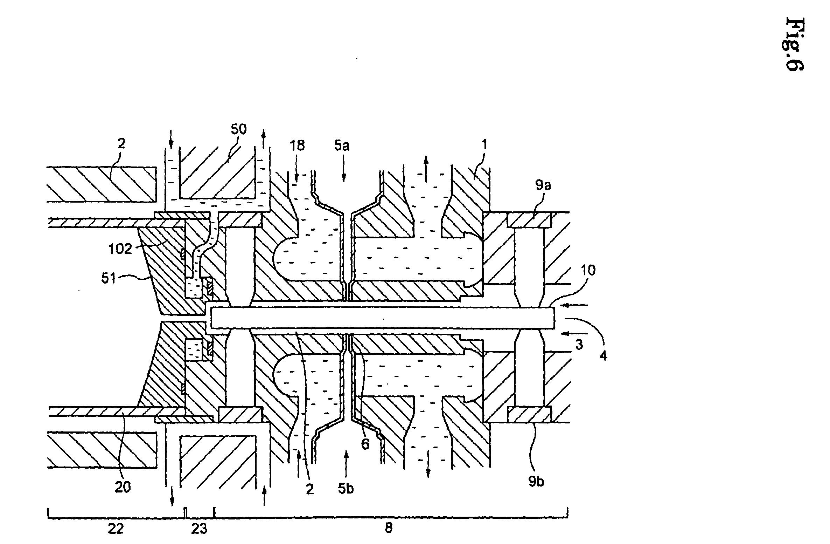

Figure 6 shows a vaporizer for MOCVD in accordance with example 3.

In this example, the radiation preventive portion 102 has a taper 51. This taper 51 eliminates a dead zone in this portion, so that the retention of raw material can be prevented.

Other points are the same as in example 2.

In this example, the detected product coincided better with the product in the reaction formula studied based on the reaction theory than in the case of example 2.

Also, the amount of carbides adhering to the external surface on the gas outlet side 7 of the dispersion section body 1 was measured, with the result that the amount of adhering carbides was nearly zero.

### [Example 4]

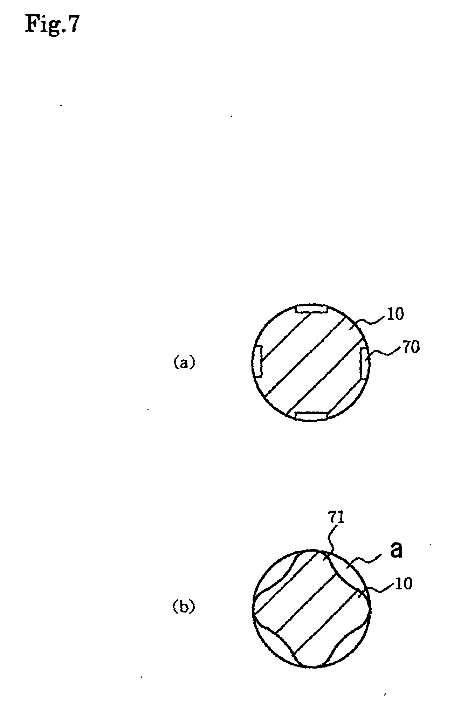

Figure 7 shows modified examples of the gas passage.

In Figure 7(a), grooves 70 are formed in the surface of the rod 10, and the outside diameter of the rod 10 is almost the same as the inside diameter of the hole formed in the dispersion section body 1. Therefore, merely by inserting the rod 10 in the hole, the rod can be arranged in the hole without eccentricity. Also, machine screws etc. need not be used. The grooves 70 serve as gas passages.

The grooves may be formed in plural numbers in parallel with the axis in the lengthwise direction of the rod 10, or they may be formed in a spiral form in the surface of the rod 10. In the case of the spiral form, a raw material gas having high homogeneity can be obtained.

Figure 7(b) shows an example in which mixing portions are provided in the tip end portion of the rod 10. The largest diameter in the tip end portion is almost the same as the inside diameter of the hole formed in the dispersion section body 1. Spaces formed by the rod tip end portion and the internal surface of hole serve as gas passages.

The examples shown in Figures 7(a) and 7(b) are examples in which the surface of the rod 10 is machined. However, it is a matter of course that a rod having a circular cross section is used, and concave portions are formed in the surface of hole to provide gas passages. It is preferable that the rod be arranged in accordance with H7 x h6 - JS7 specified in JIS.

### [Example 5]

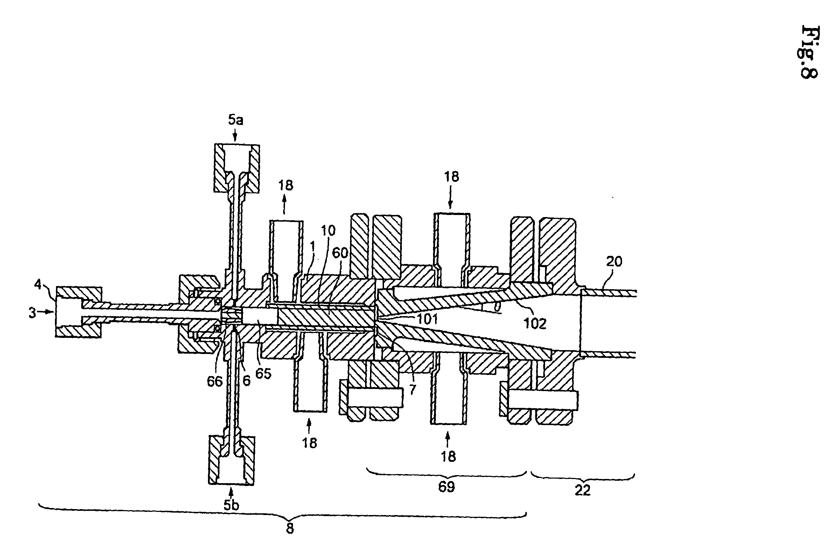

Example 5 is explained with reference to Figure 8.

The vaporizer for MOCVD of this example includes:
a dispersion section 8 having
a gas passage formed inside,
a gas introduction port 4 for introducing a pressurized carrier gas 3 into the gas passage,
means for supplying raw material solutions 5a and 5b to the gas passage, and
a gas outlet 7 for sending the carrier gas containing the raw material solutions 5a and 5b to a vaporization section 22; and
the vaporization section 22 for heating and vaporizing the carrier gas in which the raw material solutions are contained, which is sent from the dispersion section 8, having
a vaporization tube 20 one end of which is connected to a reaction tube of an MOCVD apparatus and the other end of which is connected to the gas outlet 7 of the dispersion section 8, and
heating means for heating the vaporization tube 20, and
the dispersion section 8 has a dispersion body 1 having a cylindrical hollow portion and a rod 10 having an outside diameter smaller than the inside diameter of the cylindrical hollow portion;
one or two or more spiral grooves 60 are formed on the vaporizer side at the outer periphery of the rod 10;
the rod 10 is inserted in the cylindrical hollow portion; and
a radiation preventive portion 101 is provided which has a minute hole 101 on the outside of the gas outlet 7 and the inside diameter of which spreads in a taper shape toward the vaporizer 22.

When the raw material solution 5 is supplied to the gas passage through which the high-velocity carrier gas 3 flows, the raw material solution is sheared and atomized. Specifically, the raw material solution, which is a liquid, is sheared by a high-velocity flow of carrier gas, and made particles. The raw material solution having been made particles is dispersed in the carrier gas in a particulate state. This point is the same as in example 1.

In order to accomplish the shearing and atomization in the optimum manner, the following conditions are favorable.

The raw material solution 5 is supplied preferably at 0.005 to 2 cc/min, more preferably at 0.005 to 0.02 cc/min, and still more preferably at 0.1 to 0.3 cc/min. When a plurality of raw material solutions (including solvent) are supplied at the same time, the total quantity thereof should preferably be as described above.

Also, the carrier gas is supplied preferably at a rate of 10 to 200 m/sec, more preferably at a rate of 100 to 200 m/sec.

There is a mutual relation between the flow rate of raw material solution and the flow rate of carrier gas. It is a matter of course to select a cross-sectional area and a shape of flow path that realizes the optimum shearing and atomization and can obtain ultrafine particle mist.

In this example, the spiral groove 60 is formed at the outer periphery of the rod 10, and a gap space is present between the dispersion section body 1 and the rod 10. Therefore, the carrier gas containing the atomized raw material solution goes straight in this gap space as a straight flow, and also forms a swirl flow along the spiral groove 60.

The inventor found that the atomized raw material solution is dispersed uniformly in the carrier gas in the state in which the straight flow and the swirl flow coexist. The reason why uniform dispersion can be obtained if the straight flow and the swirl flow coexist is not necessarily clear. However, the following reason is possible. The existence of swirl flow produces a centrifugal force in the flow, and a secondary flow is produced. This secondary flow accelerates the mixture of the raw material with the carrier gas. That is, it is considered that the secondary derived flow is produced in the direction perpendicular to the flow by the centrifugal effect of swirl flow, and thereby the atomized raw material solution is dispersed uniformly in the carrier gas.

Next, this example is explained in more detail.

In this example, the configuration is such that as one example, four kinds of raw material solutions 5a, 5b, 5c and 5d (5a, 5b and 5c are organic metal raw materials and 5d is a solvent raw material such as THF) are supplied to the gas passage.

In order to mix the carrier gas containing the raw material solutions having been atomized and made in an ultrafine particle shape (referred to as a "raw material gas"), in this example, a portion in which the spiral groove is absent is provided on a downstream side of a portion corresponding to a raw material supply hole 6 of the rod 10. This portion serves as a premixing portion 65. In the premixing portion 65, the raw material gas of three kinds of organic metals is mixed to some extent, and further a perfectly mixed raw material gas is formed in the region of the downstream spiral structure. In order to obtain a uniformly mixed raw material gas, the length of the mixing portion 65 is preferably 5 to 20 mm, more preferably 8 to 15 mm. If the length thereof is out of the above range, only on kind of mixed raw material gas with a high concentration of the raw material gases of three kinds of organic metals is sometimes sent to the vaporization section 22.

In this example, an end portion 66 on the upstream side of the rod 10 is provided with a parallel portion 67 and a taper portion 58. In the cylindrical hollow portion of the dispersion section body 1 as well, a parallel portion having an inside diameter equal to the outside diameter of the parallel portion 67 of the rod 10, which corresponds to the parallel portion 67, and a taper portion with the same taper as the taper of the rod 10, which corresponds to the taper portion 58, are provided. Therefore, when the rod 10 is inserted from the left-hand side in the figure, the rod 10 is held in the hollow portion of the dispersion section body 1.

In this example, unlike the case of example 1, since the rod 10 is held with the taper being provided, even if a carrier gas having a pressure higher than 3 kgf/cm² is used, the rod 10 can be prevented from moving. Specifically, if the holding technique shown in Figure 8 is employed, the carrier gas can be caused to flow at a pressure equal to or higher than 3 kgf/cm². As a result, the cross-sectional area of gas passage is decreased, and a higher-velocity carrier gas can be supplied by a small quantity of gas. Specifically, a carrier gas with a high velocity of 50 to 300 mm/s can be supplied. The same is true if this holding technique is employed in the above-described other examples.

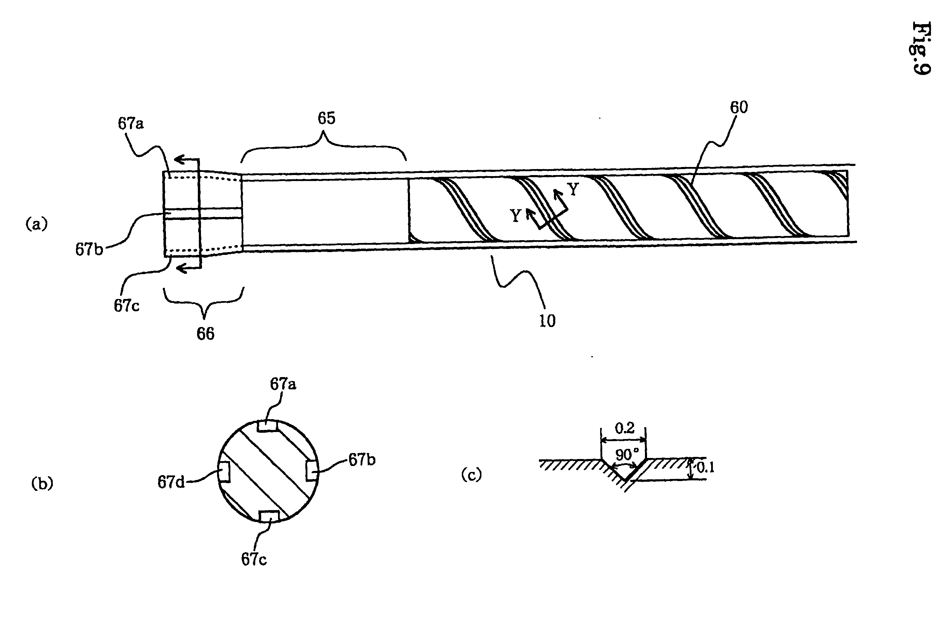

As shown in Figure 9(b), in a portion corresponding to the raw material supply hole 6 of the rod 10, grooves 67a, 67b, 67c and 67d are formed as carrier gas passages. The depth of each of the grooves 67a, 67b, 67c and 67d is preferably 0.005 to 0.1 mm. If the depth thereof is shallower than 0.005 mm, the machining of groove is difficult. Also, the depth thereof is more preferably 0.01 to 0.05 mm. The depth in this range prevents the occurrence of clogging etc. Also, it can easily provide a high-velocity flow.

For the holding of the rod 10 and the formation of gas passage, the construction shown in Figure 1 in example 1 or other constructions may be used.

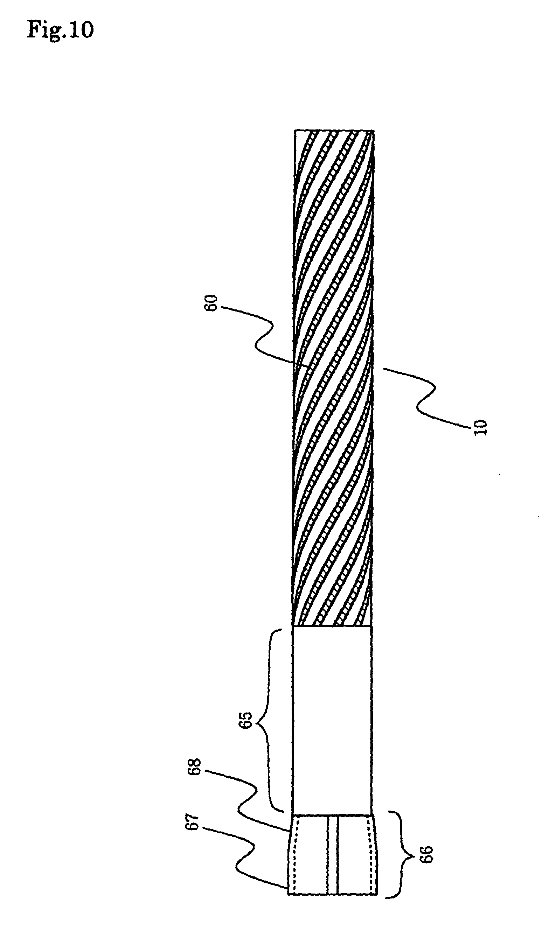

The number of the spiral grooves 60 may be one as shown in Figure 9(a), or may be any plural numbers as shown in Figure 10. Also, when the plurality of spiral grooves are formed, they may be crossed. When the spiral grooves 60 are crossed, a raw material gas dispersed more uniformly can be obtained. However, the cross-sectional area should be such that a gas flow velocity equal to or higher than 10 m/sec can be obtained in each groove.

The size and shape of the spiral groove 60 is not subject to any special restriction. The size and shape shown in Figure 9(c) is one example.

In this example, as shown in Figure 8, the gas passage is cooled by cooling water 18.

Also, in this example, an expansion section 69 is independently provided in front of the inlet of the dispersion section 22, and the lengthwise radiation preventive portion 102 is arranged in this expansion section 69.

The minute hole 101 is formed on the gas outlet 7 side of the radiation preventive portion, and the inside diameter of the minute hole 101 spreads in a taper shape toward the vaporizer side.

The expansion section 69 also serves to prevent the retention of raw material gas, which has been described in example 3. Needless to say, there is no need for independently provide the expansion section 69. The integrated construction as shown in Figure 6 may also be used.

The expansion angle θ of the expansion section 69 is preferably 5 to 10 degrees. When the expansion angle θ is within this range, the raw material gas can be supplied to the dispersion section without destroying the swirl flow. Also, when the expansion angle θ is within this range, the fluid resistance due to expansion becomes a minimum and also the presence of dead zone becomes a minimum, so that the presence of eddy current due to the presence of dead zone can be made a minimum. The expansion angle θ is more preferably 6 to 7 degrees. In the case of the example shown in Figure 6 as well, the preferable range of θ is the same.

### [Example 6]

The apparatus shown in Figure 8 was used, and the raw material solutions and the carrier gas were supplied under the following conditions, by which the homogeneity of raw material gas was investigated.

| Quantity of introduced raw material solutions: | |
|---|---|
| Sr(DPM)₂ | 0.04 cc/min |
| Bi(C₆H₅)₃ | 0.08 cc/min |
| Ta(OC₂H₅)₅ | 0.08 cc/min |
| THF | 0.2 cc/min |
| Carrier gas: nitrogen gas | 10 to 350 m/s |

As a vaporizing apparatus, the apparatus shown in Figure 8 was used. As a rod, the rod shown in Figure 9, which is not formed with the spiral groove, was used.

The raw material solutions were supplied from the raw material supply hole 6, and the carrier gas was supplied by changing the velocity thereof variously. From the raw material supply hole, Sr(DPM)₂ was supplied to the groove 67a, Bi(C₆H₅)₃ was supplied to the groove 67b, Ta(OC₂H₅)₅ was supplied to the groove 67c, and THF and other solvents were supplied to the groove 67d.

Heating was not performed in the vaporization section, and the raw material gas was sampled at the gas outlet 7 to measure the particle diameter of raw material solution in the sampled raw material gas.

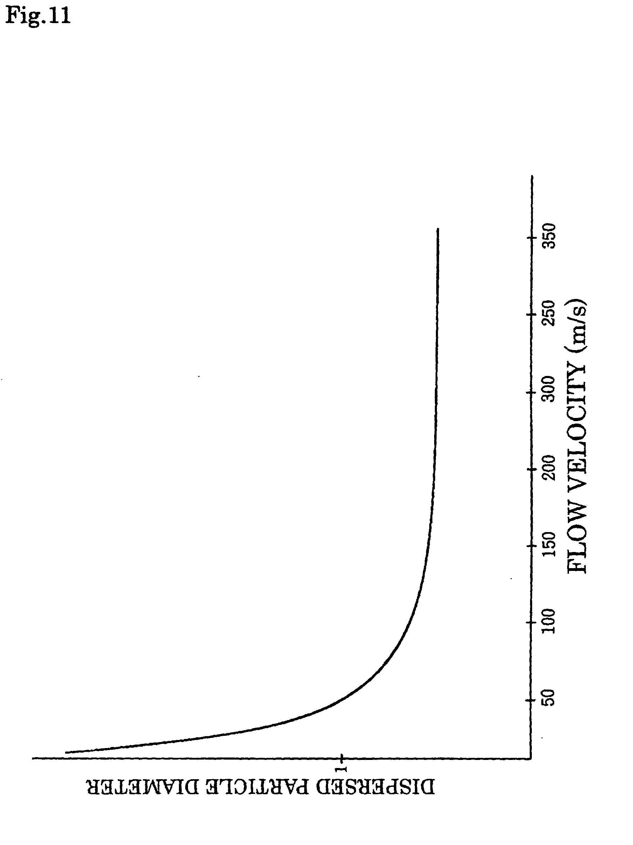

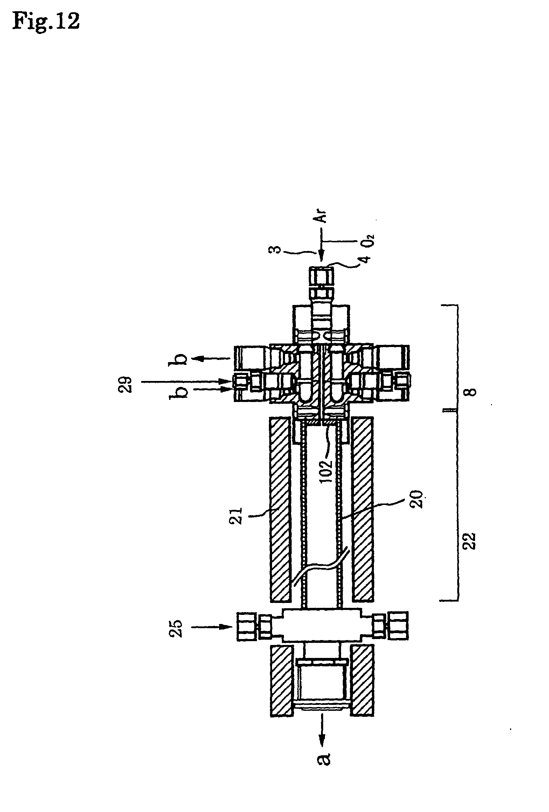

The measurement result is shown in Figure 11 as a relative value (the case where the apparatus of the conventional example shown in Figure 12(a) is taken as 1). As seen from Figure 11, by rendering the flow velocity equal to or higher than 50 m/s, the dispersed particle diameter decreases, and by rendering the flow velocity equal to or higher than 100 m/s, the dispersed particle diameter further decreases. However, when the flow velocity is rendered equal to or higher than 200 m/s, the dispersed particle diameter saturates. Therefore, the preferred range is 100 to 200 m/s.

### [Example 7]

In example 7, a rod formed with a spiral groove was used.

Other points are the same as in example 6.

In example 6, in an extended portion of the groove, the concentration of raw material solution supplied to the groove was high. Specifically, in an extended portion of the groove 67a, the concentration of Sr(DPM)₂ was high, in an extended portion of the groove 67b, the concentration of Bi(C₆H₅)₃ was high, and in an extended portion of the groove 67b, the concentration of Ta(OC₂H₅)₅ was high.

However, in this example, for the mixed raw material gas obtained at the end of spiral groove, each organic metal raw material was uniform in any portions.

### [Example 8]

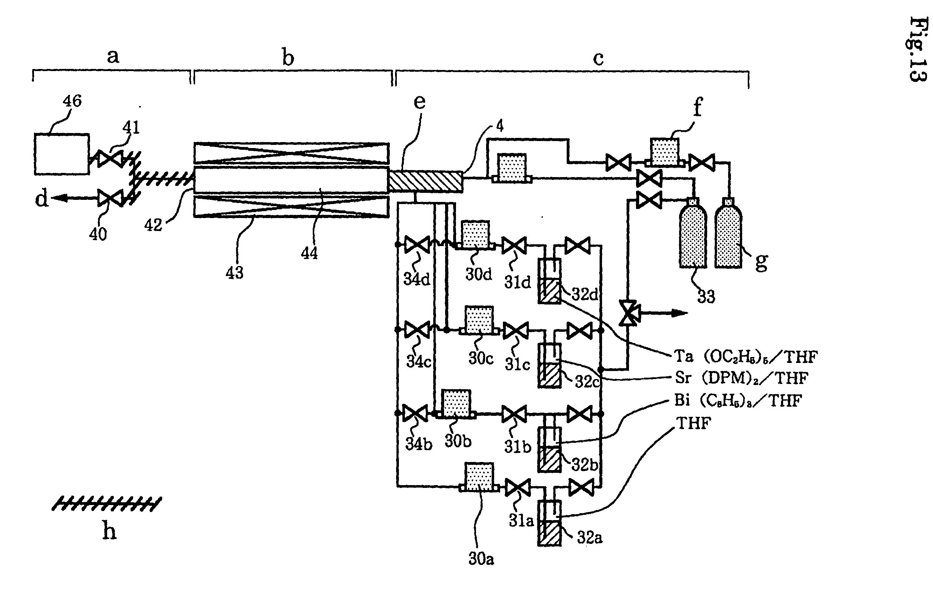

### Example 8 is shown in Figures 12 and 13.

Conventionally, oxygen has been introduced only on the downstream side of the vaporization section 22 as shown in Figure 2. As described in the section of conventional technique, a large quantity of carbon is contained in the film formed by the conventional technique. Also, the composition in the raw material and the composition in the formed film have been different from each other. Specifically, when vaporization and film formation are accomplished by adjusting the raw material to the stoichiometric composition, the actually formed film has a composition different from the stoichiometric composition. In particular, a phenomenon such that bismuth is scarcely contained (about 0.1 at%) has been observed.

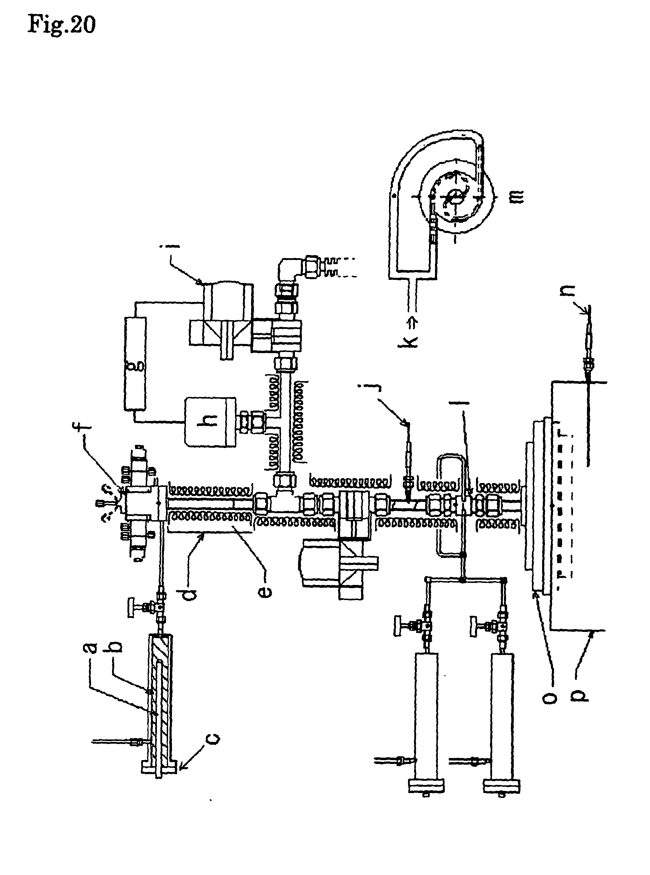

The inventor found that the cause for this relates to the introduction position of oxygen. Specifically, it was found that if as shown in Figure 20, if oxygen is introduced, together with the carrier gas, from a gas introduction port 4, a secondary oxygen supply port 200 just near a blowoff port, and a oxygen introduction port (primary oxygen supply port) 25, the difference between the composition in the formed film and the composition in the raw material solution can be made extremely small.

It is optional to mix oxygen with the carrier gas in advance and to introduce this mixed gas through the gas introduction port 4.

### [Example 9]

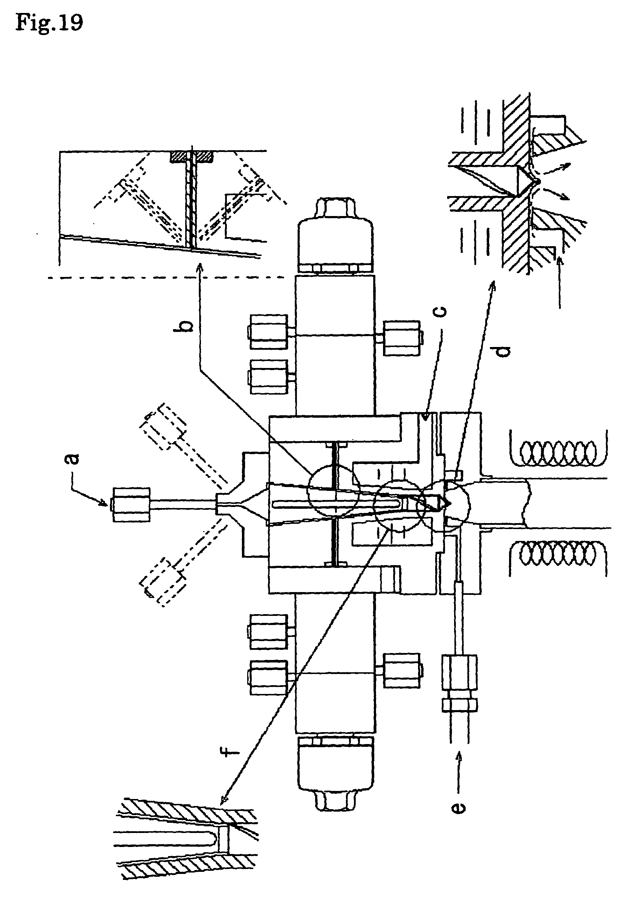

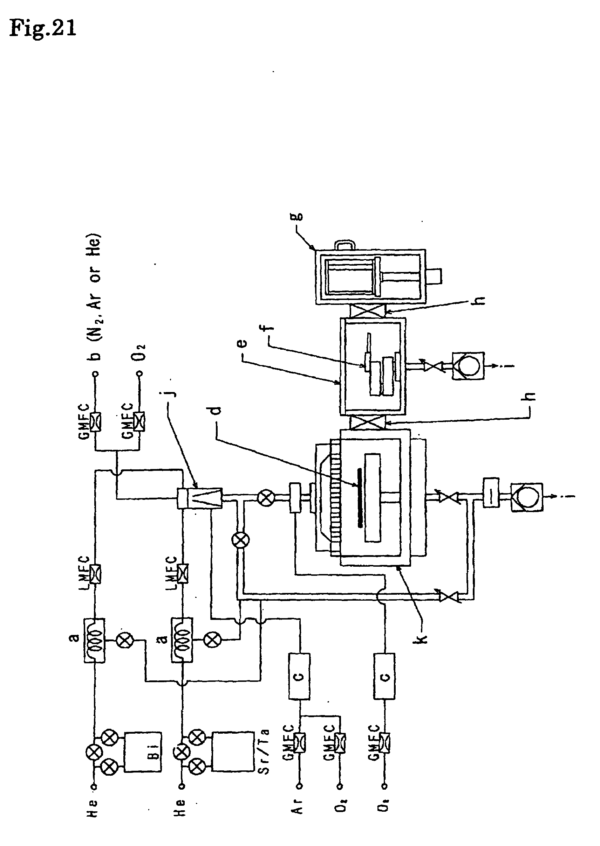

By using the vaporizer shown in Figures 19 and 20 and the CVD apparatus shown in Figure 21, an SBT film was formed, and further polarization characteristics etc. were evaluated.

Concretely, the conditions of vaporizer and reaction chamber were controlled as described below, and an SBT film was formed on a substrate obtained by forming platinum of 200 nm on an oxidized silicon substrate.

### Concrete conditions:

Hexaethoxystrontiumtantalum Sr[Ta(OC₂H₅)₆]₂ 0.1 mol
solution (solvent: hexane) 0.02 ml/min
Tri-t-amyloxide bismuth Bi(O-t-C₅H₁₁)₃ 0.2 mol solution (solvent: hexane) 0.02 ml/min
First carrier Ar = 200 sccm (introduced through a gas introduction port 4)
First carrier O₂ = 10 sccm (introduced through a gas introduction port 4)
Second carrier Ar = 20 sccm (introduced through a gas introduction port 200)
O₂ = 10 sccm (introduced through a gas introduction port 200)
Reaction oxygen O₂ = 200 sccm (introduced from a dispersion blowoff portion lower portion 25)
Reaction oxygen temperature 216°C (temperature is controlled by a heater provided separately before reaction oxygen is introduced from a dispersion blowoff portion lower portion)
Wafer temperature 475°C
Space temperature 299°C
Space distance 30 mm
Shower head temperature 201°C
Reaction pressure 1 Torr
Film forming time 20 minutes

### Results:

SBT film thickness about 300 nm (deposition speed about 150 nm/min)
SBT composition

| | |
|---|---|
| Sr | 5.4 at% |
| Bi | 16.4 at% |
| Ta | 13.1 at% |
| O | 61.4 at% |
| C | 3.5 at% |

The difference between the composition in the formed film and the composition in the raw material solution was very small, and the deposition speed was about five times the conventional speed. It is found that the effect of introducing small amount of oxygen through the gas introduction port 4 together with the carrier gas is extremely great. The carbon content is as low as 3.5 at%.

Because the temperature of the reaction oxygen (200 cc/min) was precisely controlled (to 216°C) by the separately provided heater before the reaction oxygen was introduced from the dispersion blowoff portion lower portion 25, from the fact that contamination of the lower part of evaporation tube was eliminated, it was verified that the effect of restraining the re-condensation/sublimation(solidification) of vaporized organic metal compound is great.

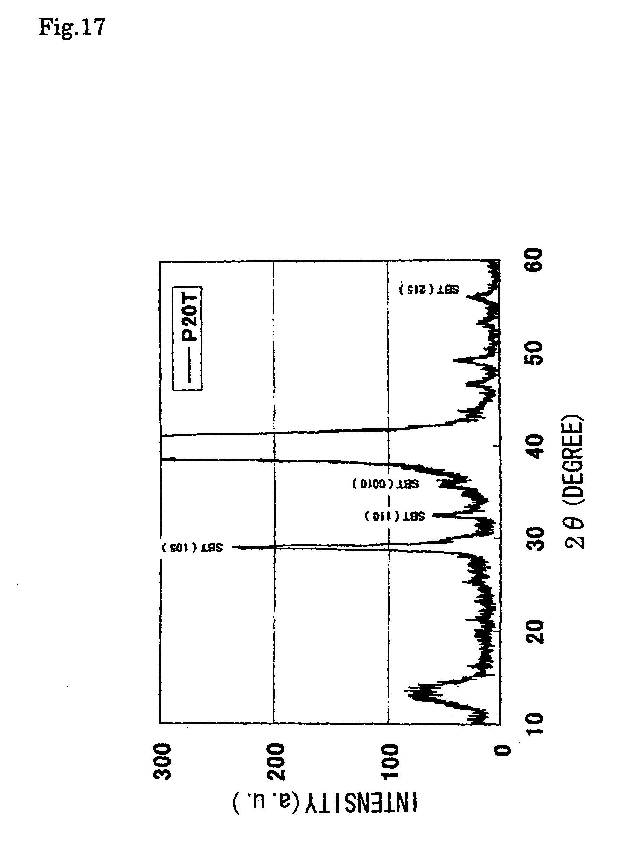

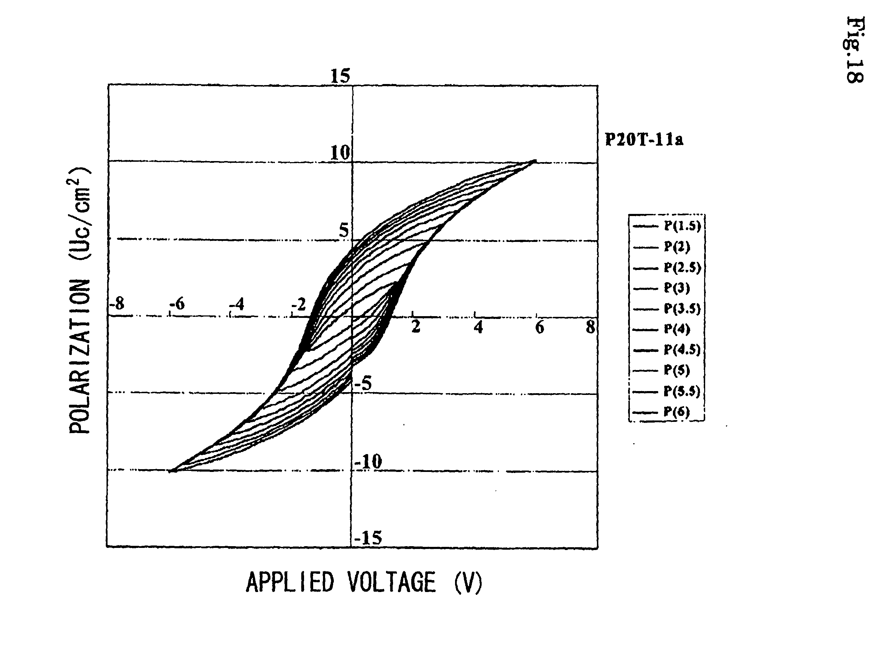

After the SBT thin film has been formed, crystallization treatment was performed at 750°C for 30 minutes in an oxygen atmosphere, and measurement and evaluation were carried out by forming an upper electrode. As a result, high crystallization characteristics and polarization characteristics were exhibited. These results are shown in Figures 17 and 18.

If an oxidizing gas such as oxygen is merely introduced through the gas introduction port 4 or a primary oxygen supply port just near a blowoff port, it is preferable that, as shown in figure 2, oxygen be introduced at the same time on the downstream side of a vaporization section and the quantity of oxygen be controlled appropriately, because by doing this, the difference in composition is decreased and the carbon content is also decreased.

The content of carbon in the formed film can be decreased to 5 to 20% of the conventional example.

An example of an SBT thin film deposition process is explained with reference to Figure 20.

A valve 2 is opened, and a valve 1 is closed, by which a reaction chamber is evacuated to a high vacuum. After several minutes, a wafer is transferred from a load lock chamber to a reaction chamber.

At this time, in a vaporizer, hexaethoxystrontiumtantalum (Sr[Ta(OC₂H₅)₆]₂ 0.1 mol solution (solvent: hexane) 0.02 ml/min),
tri-t-amyloxide bismuth (Bi(O-t-C₅H₁₁)₃ 0.2 mol solution (solvent: hexane) 0.02 ml/min),
first carrier Ar (= 200 sccm (introduced through a gas introduction port 4)), and
first carrier O₂ (= 10 sccm (introduced through a gas introduction port 4))
flow and are drawn to a vacuum pump through the valve 2 and an automatic pressure regulating valve.

At this time, the pressure gage is controlled to 4 Torr by the automatic pressure regulating valve.

When the temperature becomes stable several minutes after the wafer has been transferred, the valve 1 is opened, and the valve 2 is closed, by which the following gas is caused to flow into the reaction chamber to start deposition.
Hexaethoxystrontiumtantalum Sr[Ta(OC₂H₅)₆]₂ 0.1 mol solution (solvent: hexane) 0.02 ml/min
Tri-t-Amyloxide bismuth Bi(O-t-C₅H₁₁)₃ 0.2 mol solution (solvent: hexane) 0.02 ml/min
First carrier Ar = 200 sccm (introduced through the gas introduction port 4)
First carrier O₂ = 10 sccm (introduced through the gas introduction port 4)
Second carrier Ar = 20 sccm (introduced through the gas introduction port 200)
O₂ = 10 sccm (introduced through the gas introduction port 200)
Reaction oxygen O₂ = 200 sccm (introduced from the dispersion blowoff portion lower portion 25)
Reaction oxygen temperature 216°C (temperature is controlled by the heater provided separately before reaction oxygen is introduced from the dispersion blowoff portion lower portion)
Wafer temperature 475°C

The reaction pressure chamber pressure is controlled to 1 Torr (by a not described automatic pressure regulating valve).

After predetermined time (20 minutes, in this example) has elapsed, the valve 2 is opened, and the valve 1 is closed, by which the deposition is finished.

The reaction chamber is evacuated to a high vacuum to remove the reaction gas completely, and after one minute, the wafer is taken out to the load lock chamber.

### Capacitor structure

Pt(200 nm)/CVDSBT(300 nm)/Pt(175 nm)/Ti(30 nm)/SiO₂/Si

### Capacitor forming process

Lower electrode formation Pt(175 nm)/TI(30 nm) CVDSBT film formation (300 nm)
SBT film crystallization treatment (diffusion furnace
annealing: wafer 750°C, 30 min, O₂ atmosphere)
Upper electrode formation Pt(200 nm)
Annealing: 650°C, O₂, 30 min

Conventionally, since the reaction oxygen (for example, 200 sccm) has been put in the vaporization tube in a room temperature state, the organic metal gas has been cooled, and adhered and deposited in the vaporization tube.

When the temperature of the reaction oxygen supplied from the lower portion of evacuation section is controlled, conventionally, a heater has been wound around a stainless steel tube (outside dimension: 1/4 to 1/16 inch, length: 10 to 100 cm) to control the temperature of external wall of the stainless steel tube (to 219°C, for example).

It has been considered that the temperature of external wall of the stainless steel tube (219°C, for example) is equal to the temperature of oxygen (flow rate: 200 sccm) flowing inside.

However, the measurement of oxygen temperature with a minute thermocouple revealed that the temperature rise is only about 35°C in this example.

Therefore, the temperature of oxygen after being heated was measured directly with a minute thermocouple, and the heater temperature was controlled, by which the oxygen temperature was controlled accurately.

Since it was not easy to raise the temperature of gas such as oxygen flowing in the tube, the heat exchange efficiency was improved by putting a filler in the heating tube, and the temperature of heated oxygen gas was measured, by which the heater temperature was controlled properly.

Means for such control is a heat exchanger shown in Figure 20.

### [Example 10]

Example 10 is shown in Figure 14.

In the above-described examples, gas is blown to each of the raw material solutions to atomize the single raw material solution, and subsequently, the atomized raw material solutions are mixed with each other. This example provides an apparatus in which a plurality of raw material solutions are mixed, and the mixed raw material solutions are atomized.

The evaporator of this example includes:
a disperser 150 formed with a plurality of solution passages 130a and 130b for supplying raw material solutions 5a and 5b, a mixing section 109 for mixing the raw material solutions 5a and 5b supplied through the solution passages 130a and 130b, a supply passage 110 one end of which communicates with the mixing section 109 and which has an outlet 017 on the vaporization section 22 side, a gas passage 120 arranged so that a carrier gas or a mixed gas of the carrier gas and oxygen is blown to the mixed raw material solution coming from the mixing section 109 in the supply passage 110, and cooling means for cooling the interior of the supply passage 110; and
a vaporization section 22 for heating and vaporizing the gas containing the raw material solutions, which is sent from the disperser 150, having a vaporization tube one end of which is connected to a reaction tube of an MOCVD apparatus and the other end of which is connected to the outlet 107 of the disperser 150, and heating means 2 for heating the vaporization tube, and
a radiation heat preventive material 102 having a minute hole 101 is arranged on the outside of the outlet 107.

This example is effective for the raw material solutions the reaction of which does not proceed even if being mixed. Since the raw material solutions are atomized after being once mixed, the composition is exact as compared with the case where the raw material solutions are mixed after being atomized. Also, means (not shown) for analyzing the composition of mixed raw material solution in the mixing section 109 is provided, and the supply amounts of the raw material solutions 5a and 5b are controlled based on the analysis result, by which more exact composition can be obtained.

Also, in this example, a rod (reference numeral 10 in Figure 1) need not be used. Therefore, the heat propagating in the rod does not heat the interior of the supply passage 110. Further, the cross-sectional area of the supply passage 110 can be decreased as compared with the case where the raw material solutions are mixed after being atomized, and hence the cross-sectional area of the outlet 107 can be decreased, so that the interior of the supply passage 110 is scarcely heated by radiation. Therefore, the deposition of crystals can be decreased without providing the radiation preventive portion 102. In the case where it is desired to further prevent the deposition of crystals, the radiation preventive portion 102 may be provided as shown in Figure 14.

Although the number of minute holes is one in the above-described examples, it is a matter of course that number of minute holes may be plural. Also, the diameter of the minute hole is preferably equal to or smaller than 2 mm. When a plurality of minute holes are provided, the diameter can be made far smaller.

Also, in the above-described examples, in the case where the carrier flow path and the raw material solution introduction port make an acute angle (30 degrees), the solution is drawn by the gas. If the angle is equal to or larger than 90 degrees, the solution is pushed by the gas. Therefore, the angle is preferably 30 to 90°. Concretely, the optimum angle is determined from the viscosity and flow rate of solution. When the viscosity is high or the flow rate is high, the solution is caused to flow smoothly by making the angle more acute. Therefore, in implementation, the optimum angle corresponding to the viscosity and flow rate has only to be determined in advance by an experiment etc.

Also, in the above-described examples, it is optional to provide a mechanism for controlling the distance of space between a shower head and a susceptor to an arbitrary distance.

Furthermore, it is preferable that a liquid mass-flow controller for controlling the flow rate of raw material solution be provided, and degassing means for gas removal be provided on the upstream side of the liquid mass-flow controller. If degassing is not accomplished and the raw material solution is introduced to the mass-flow controller, variations in the formed films occur on the same wafer or between wafers. By introducing the raw material solution to the mass-flow controller after the removal of helium etc., the above-described variations in film thickness are decreased remarkably.

By providing means for controlling the temperature of raw material solution, helium transfer container, liquid mass-flow controller, and pipes in front of and behind the mass-flow controller to a fixed temperature, the variations in film thickness can further be prevented. Also, the change of properties of a chemically unstable raw material solution can be prevented. When the SBT thin film is formed, control is precisely carried out in the range of 5 to 20°C. The range of 12°C ± 1°C is especially preferable.

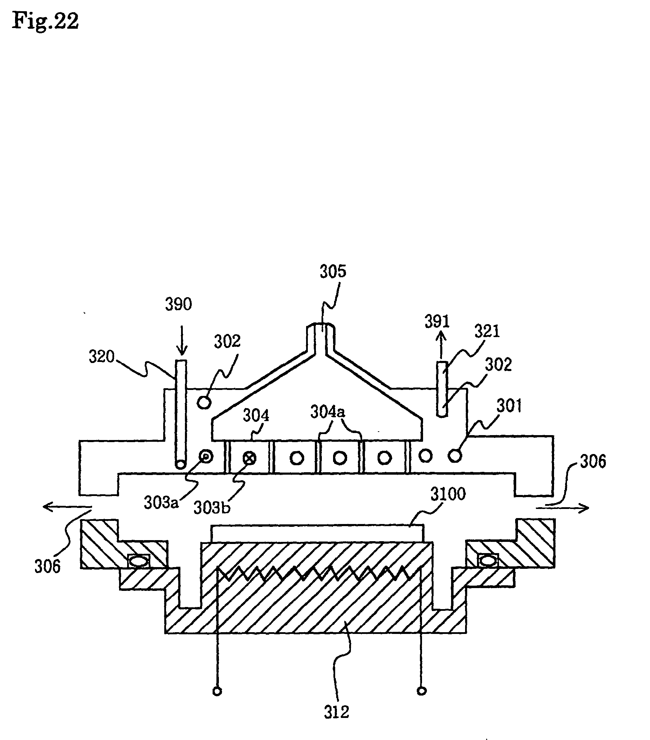

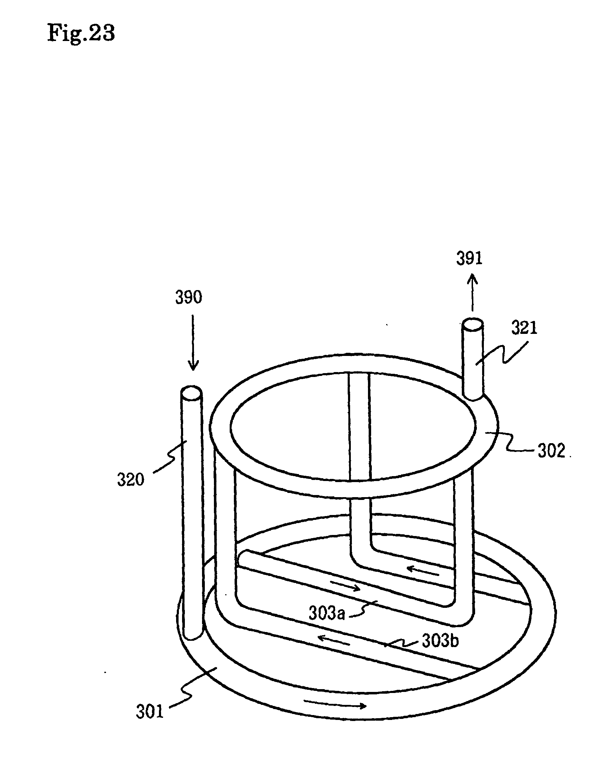

Also, in a substrate surface treatment apparatus in which a predetermined gas is blown to the substrate surface of a silicon substrate etc. to carry out surface treatment on the substrate surface as shown in Figures 22 and 23, it is optional to configure a heating medium circulation path having an upstream ring 301 connected to a heating medium inlet 320 for once-through flow of heating medium, a downstream ring 302 connected to a heating medium outlet 321 for a predetermined heating medium, and at least two heat transfer paths 303a and 303b which connect the upstream ring 1 and the downstream ring 2 to each other in the parallel direction, for making the gas at a predetermined temperature by alternating the flow path direction from the upstream ring 1 to the downstream ring 302 between the adjacent heat transfer paths 303a and 303b.

Also, the substrate surface treatment apparatus preferably has a heat conversion plate 304 thermally connected to the heating medium circulation path in a predetermined plane in the heating medium circulation path and in a plane formed in the flow path of the heating medium in the parallel direction so that the portion in the plane of the heat conversion plate 304 can be heated to a substantially uniform temperature by the heating medium.

Further, in the plane of the heat conversion plate 304, a plurality of vent holes for causing the predetermined gas to pass through in the vertical direction of the plane are preferably formed so that the predetermined gas passing through the vent hole can be heated to a substantially uniform temperature in the plane.

Thereupon, the configuration is such that the flow path direction from the upstream ring to the downstream ring between the adjacent heat transfer paths of the heating medium circulation path is alternated. Therefore, the difference in temperature in a region adjacent to the heat transfer path is configured so as to be high/low/high/low .... By this configuration, the heat conversion plate can be heated or cooled uniformly. Further, a heat conversion plate thermally connected to the heating medium circulation path is provided in a plane formed in the flow path of heating medium in the parallel direction. Therefore, a portion in the plane of this heat conversion. plate can be heated to a substantially uniform temperature by the heating medium.

### [Example 11]

### Regarding measures against air bubbles occurring in a CVD solution:

When the CVD solution is pressurized to 3 to 4 kg/cm² by using gas (argon, helium, etc.), and the flow rate thereof is controlled by using a liquid mass-flow controller, the pressurizing gas dissolves in the solvent (for example, hexane).

Just after the solution has passed through an MFC, the pressure of solution is decreased to 1 to 0 kg/cm² by pressure loss. Therefore, most of dissolved pressurizing gas comes out as air bubbles.

The occurring air bubbles cause fluctuations in the flow rate of solution, so that it is necessary to restrain the occurrence of air bubbles.

The solubility of gas (argon, helium, etc.) in the solvent is as described below according to Chemical Handbook (edited by The Chemical Society of Japan, revised 4th edition, published by Maruzen).
1: Solvent hexane (25°C) helium solubility 2.60e-4 mol (partial pressure 101.3 kPa)
2: Solvent hexane (25°C) argon solubility 25.2e-4 mol (partial pressure 101.3 kPa)

The argon solubility of 25.2e-4 mol means that 65cc of argon dissolves in 1 mol (130 cc) of hexane. Since the quantity of dissolution is proportional to the gas pressure, gas of two to three times the above-described quantity dissolves. The solubility of helium is about 10% of that of argon.

Next, a method for removing (degassing) the dissolved gas is carried out.

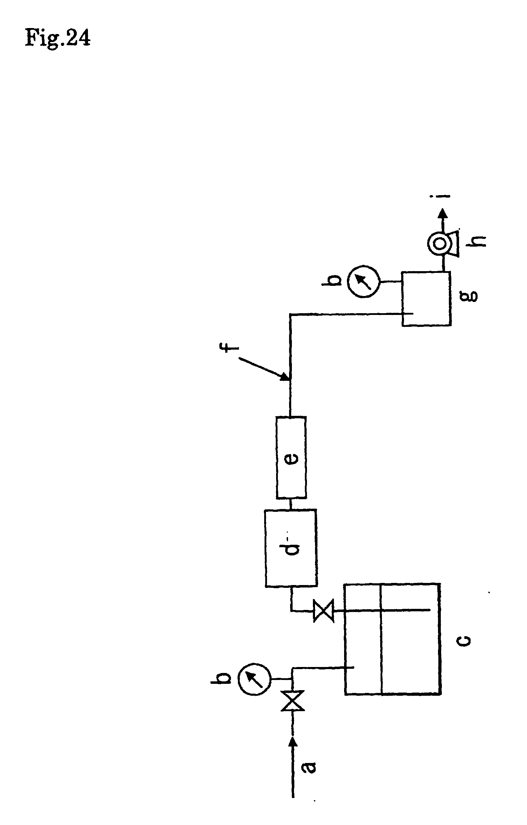

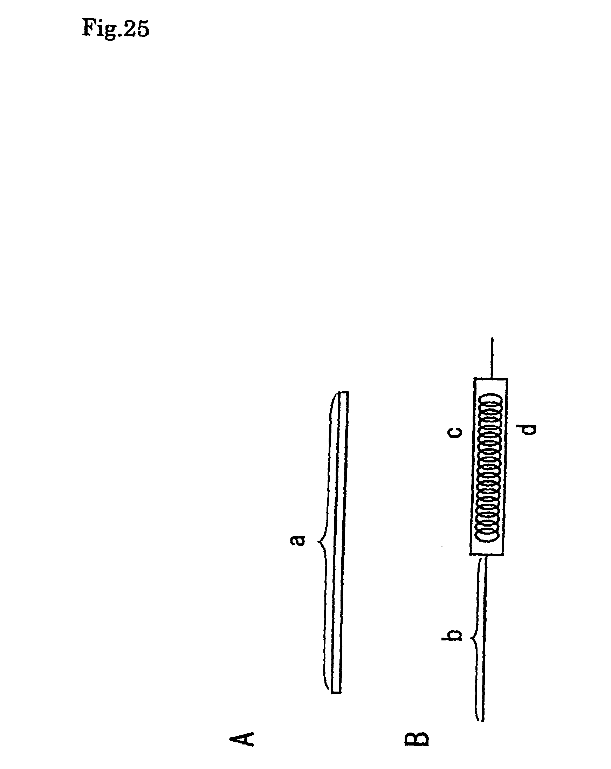

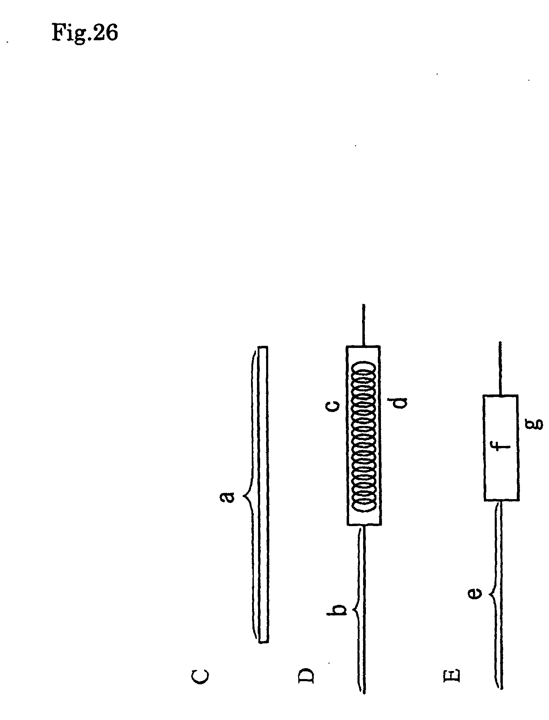

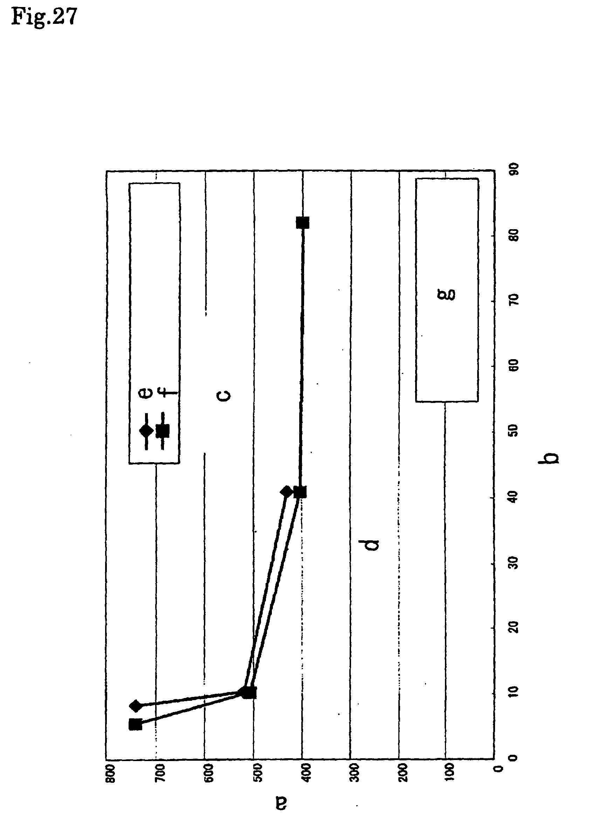

The pressurizing gas dissolves, and is observed as air bubbles when the solution is depressurized. This system is shown in Figure 24. The degassing method is shown in Figures 25 and 26. The results were summarized in Figure 27 and Table 2. Figure 26 shows an air bubble evaluating vaporizer.

It is found that when helium is used as the pressurizing gas, degassing can be accomplished to a level at which problems scarcely arise by causing the gas to pass through a PFA tube of 15 to 60 cm. However, when the pressure becomes equal to or lower than 400 Torr, air bubbles of several percent are observed, so that the solution pressure cannot be decreased to a value equal to or lower than 400 Torr.

When argon is used as the pressurizing gas, 50% or more of the interior of pipe is occupied by the occurring air bubbles.

It was found that argon can scarcely be removed even if a PFA tube having high gas permeability is used. As shown in Table 2, the vapor pressure of hexane is about 120 Torr at 20°C. Therefore, it is apparent that it is necessary to keep the pressure of hexane solution equal to or higher than 120 Torr to restrain the occurrence of air bubbles.

The properties of solvents are given in Table 3.

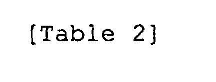

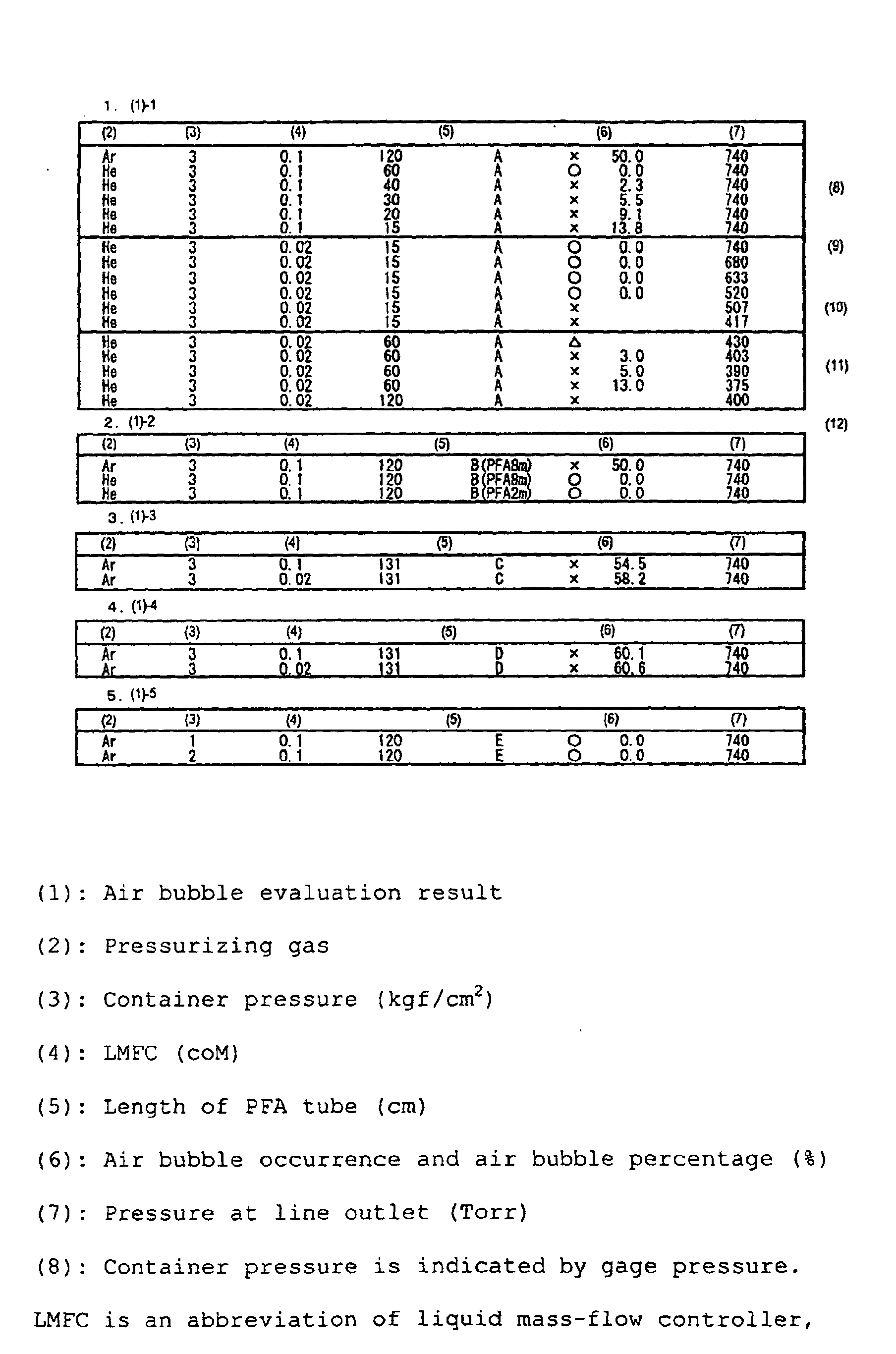

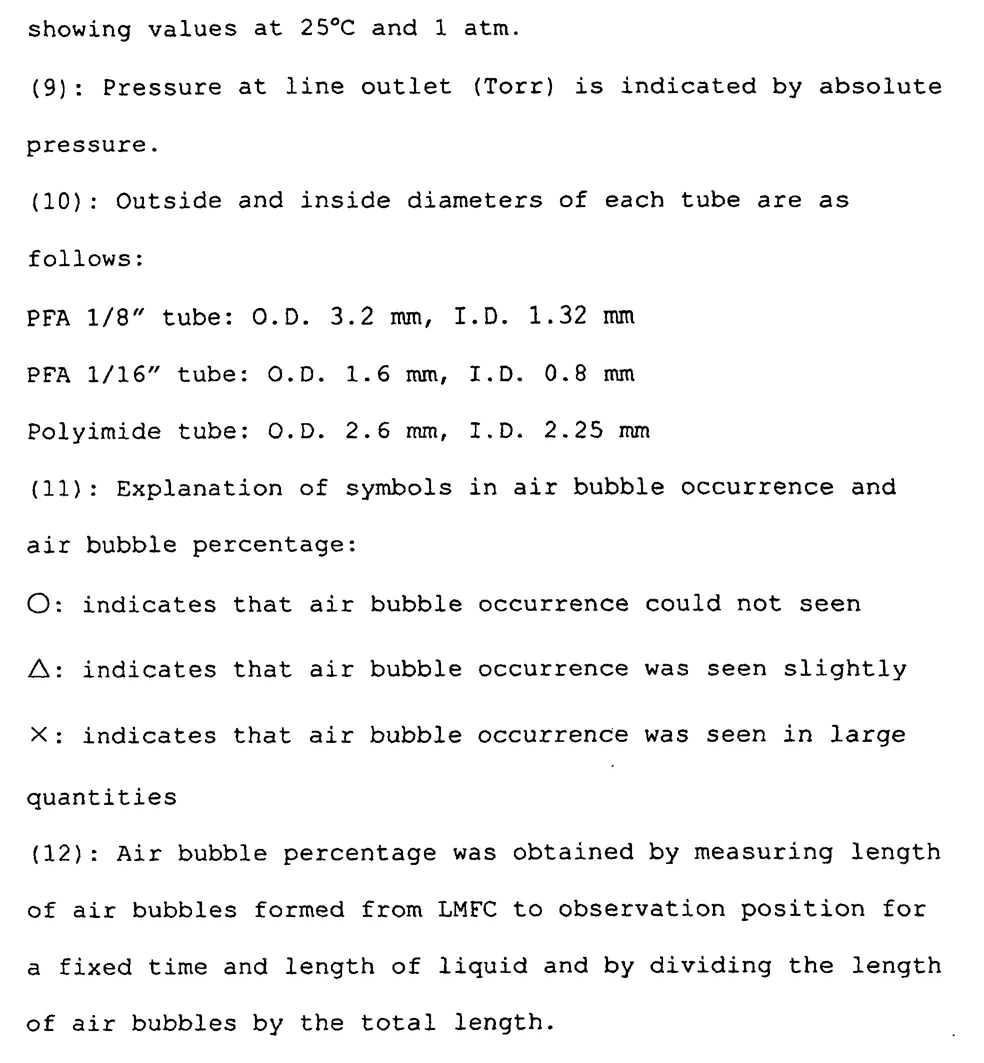

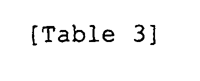

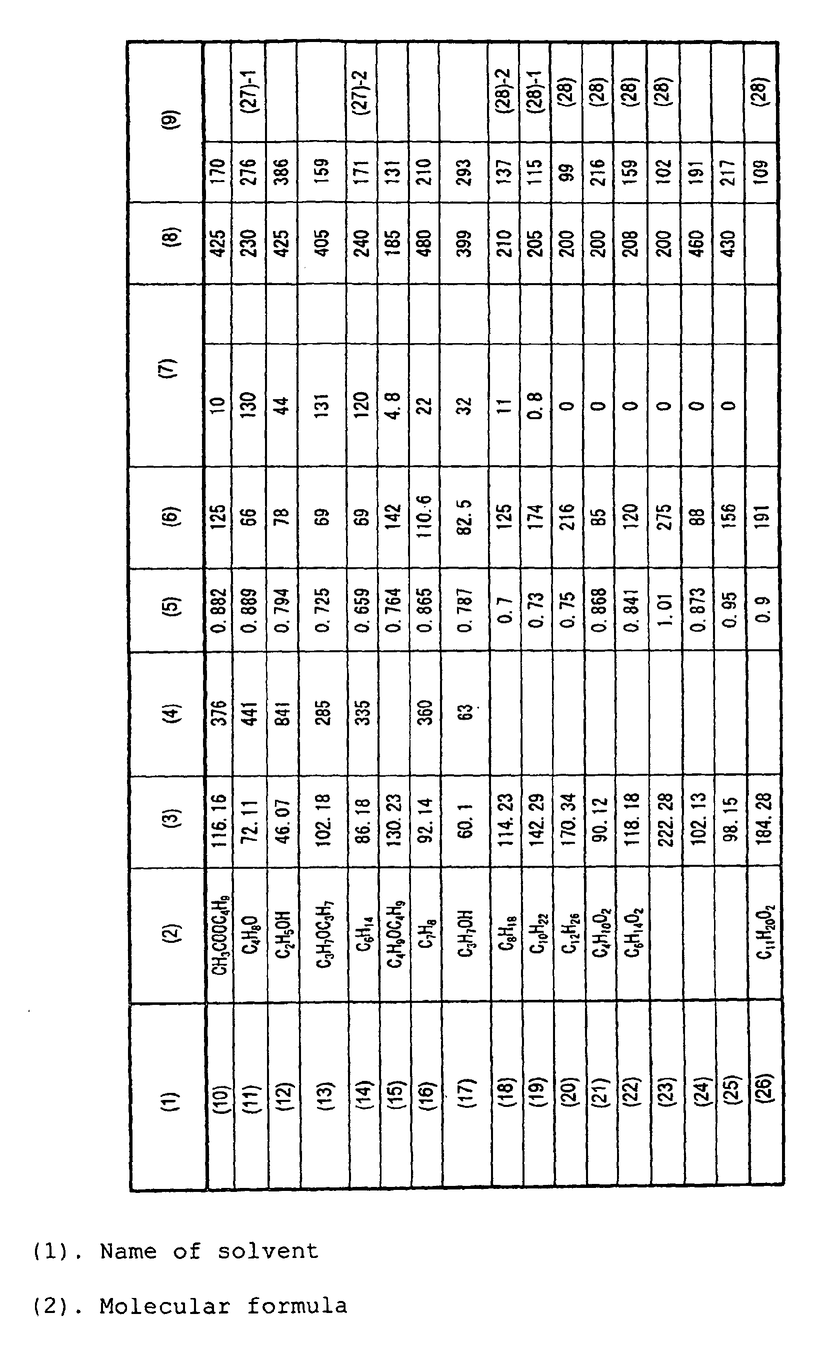

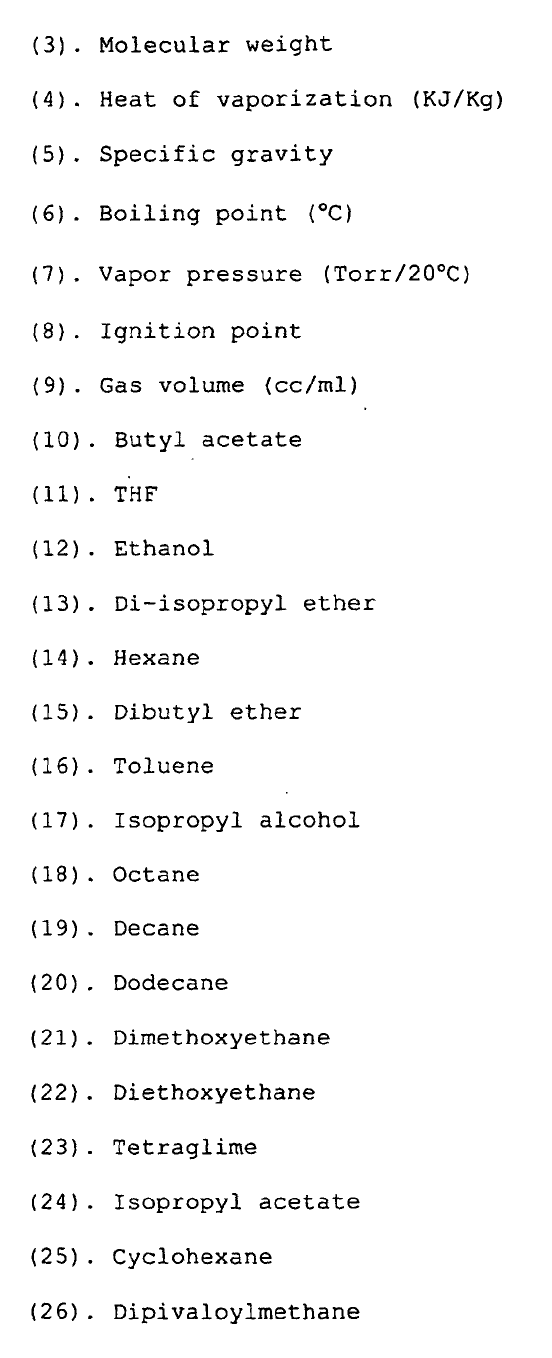

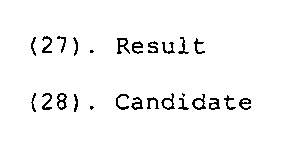

### [Example 12]

### Regarding restraint of air bubbles in depressurized vaporizer:

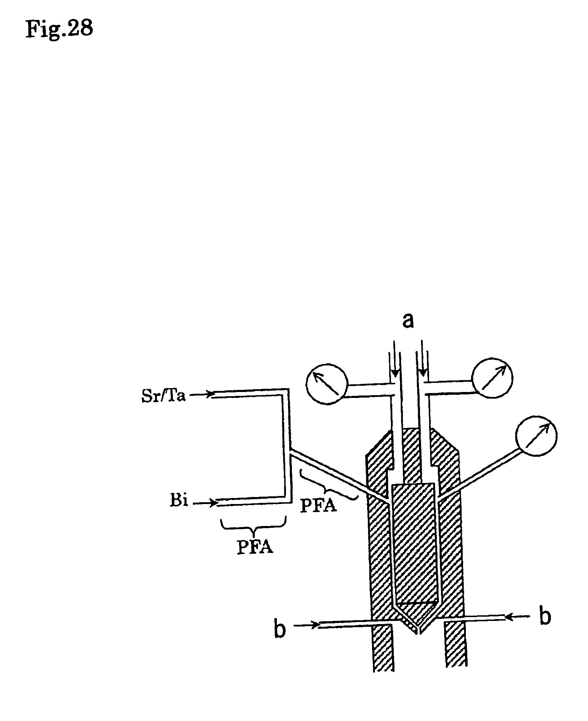

Figure 28 shows an air bubble evaluating vaporizer.

The configuration is such that Sr/Ta raw material and Bi raw material are mixed with each other in front of an evaporation head, and a source flows in one flow path of the two flow paths in the head, and only a carrier gas flows in the other flow path.

Hexane with a flow rate of 0.09 ccm was caused to flow, and the carrier pressure and air bubble occurrence were evaluated.

The results are given in Table 4. As shown in Table 4, the carrier pressure was stable, and air bubbles did not occur.

**[Table 4]**

| | | Carrier flow rate (ccm) | Carrier pressure |
|---|---|---|---|
| Condition 1 | Source side | 200 | 600 Torr |

| | | | |
|---|---|---|---|
| | Ar only | 50 | 600 |
| Condition 2 | Source side | 250 | 780 |
| | Ar only | 100 | 780 |
| Note: Carrier pressure in Table is indicated value of Bourdon tube pressure gage. | | | |

### [Example 13]

### Regarding restraint of air bubbles in depressurized vaporizer:

An example of an SBT thin film deposition process is explained with reference to Figure 21.

A valve 2 is opened, and a valve 1 is closed, by which a reaction chamber is evacuated to a high vacuum. After several minutes, a wafer is transferred from a load lock chamber to a reaction chamber.

At this time, in a vaporizer,
hexaethoxystrontiumtantalum (Sr[Ta(OC₂H₅)₆]₂ 0.1 mol
solution (solvent: hexane) 0.02 ml/min),
tri-t-amyloxide bismuth (Bi(O-t-C₅H₁₁)₃ 0.2 mol solution (solvent: hexane) 0.02 ml/min),
first carrier Ar (= 200 sccm (introduced through a gas introduction port 4)), and
first carrier O₂ (= 10 sccm (introduced through a gas introduction port 4))
flow and are drawn to a vacuum pump through the valve 2 and an automatic pressure regulating valve.

At this time, the pressure gage is controlled to 4 Torr by the automatic pressure regulating valve.

When the temperature becomes stable several minutes after the wafer has been transferred, the valve 1 is opened, and the valve 2 is closed, by which the following gas is caused to flow into the reaction chamber to start deposition.
Hexaethoxystrontiumtantalum Sr[Ta(OC₂H₅)₆]₂ 0.1 mol solution (solvent: hexane) 0.02 ml/min
Tri-t- amyloxide bismuth Bi(O-t-C₅H₁₁)₃ 0.2 mol solution (solvent: hexane) 0.02 ml/min
First carrier Ar = 200 sccm (introduced through the gas introduction port 4)
First carrier O₂ = 10 sccm (introduced through the gas introduction port 4)
Second carrier Ar = 20 sccm (introduced through the gas introduction port 200)
O₂ = 10 sccm (introduced through the gas introduction port 200)
Reaction oxygen O₂ = 200 sccm (introduced from the dispersion blowoff portion lower portion 25)
Reaction oxygen temperature 216°C (temperature is controlled by the heater provided separately before reaction oxygen is introduced from the dispersion blowoff portion lower portion)
Wafer temperature 475°C

The reaction pressure chamber pressure is controlled to 1 Torr (by a not described automatic pressure regulating valve).

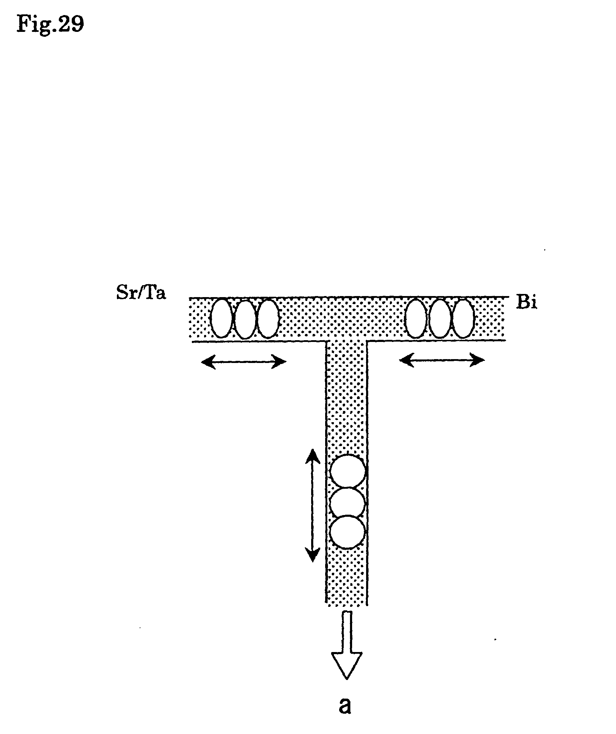

Although air bubbles were not observed before the formation of film, air bubbles began to appear after three hours from the start of film formation. Also, the pressure of carrier gas at the start time was 600 Torr, but only the pressure of carrier gas in a line through which a source is supplied varied in the range of 720 to 780 Torr. Also, air bubbles occurred at any time in both Sr/Ta and Bi systems. The air bubbles exhibit behavior of repeated advance, retreat, and stagnation (Figure 29).

### [Example 14]

### Regarding restraint of air bubbles in depressurized vaporizer:

An example of an SBT thin film deposition process is explained with reference to Figure 21.

In this example, the pressure of CVD solution was increased from the conventional 3 atm. to 4 atm. (gage pressure).

A valve 2 is opened, and a valve 1 is closed, by which a reaction chamber is evacuated to a high vacuum. After several minutes, a wafer is transferred from a load lock chamber to a reaction chamber.

At this time, in a vaporizer, hexaethoxystrontiumtantalum (Sr[Ta(OC₂H₅)₆]₂ 0.02 mol solution (solvent: hexane) 0.10 ml/min),
tri-t- amyloxide bismuth (Bi(O-t-C₅H₁₁)₃ 0.04 mol solution (solvent: hexane) 0.10 ml/min),
first carrier Ar (= 200 sccm (introduced through a gas introduction port 4)), and
first carrier O₂ (= 10 sccm (introduced through a gas introduction port 4))
flow and are drawn to a vacuum pump through the valve 2 and an automatic pressure regulating valve.

At this time, the pressure gage is controlled to 4 Torr by the automatic pressure regulating valve.

When the temperature becomes stable several minutes after the wafer has been transferred, the valve 1 is opened, and the valve 2 is closed, by which the following gas is caused to flow into the reaction chamber to start deposition.
Hexaethoxystrontiumtantalum Sr[Ta(OC₂H₅)₆]₂ 0.02 mol solution (solvent: hexane) 0.10 ml/min
Tri-t- amyloxide bismuth Bi(O-t-C₅H₁₁)₃ 0.04 mol solution (solvent: hexane) 0.10 ml/min
First carrier Ar = 200 sccm (introduced through the gas introduction port 4)
First carrier O₂ = 10 sccm (introduced through the gas introduction port 4)
Second carrier Ar = 20 sccm (introduced through the gas introduction port 200)
O₂ = 10 sccm (introduced through the gas introduction port 200)
Reaction oxygen O₂ = 200 sccm (introduced from the dispersion blowoff portion lower portion 25)
Reaction oxygen temperature 216°C (temperature is controlled by the heater provided separately before reaction oxygen is introduced from the dispersion blowoff portion lower portion)
Wafer temperature 475°C

The reaction pressure chamber pressure is controlled to 1 Torr (by a not described automatic pressure regulating valve).

Before the start of film formation, air bubble were not observed. Even after 10 hours has elapsed from the start of film formation, air bubbles did not appear.

In example 13, it was considered that the carrier gas was caused to flow backward in a solution line by fluctuations in the pressure of carrier gas caused by the occurring air bubbles. Therefore, the pressure of solution was increased, and hence the flow rate thereof was increased, by which this problem could be solved.

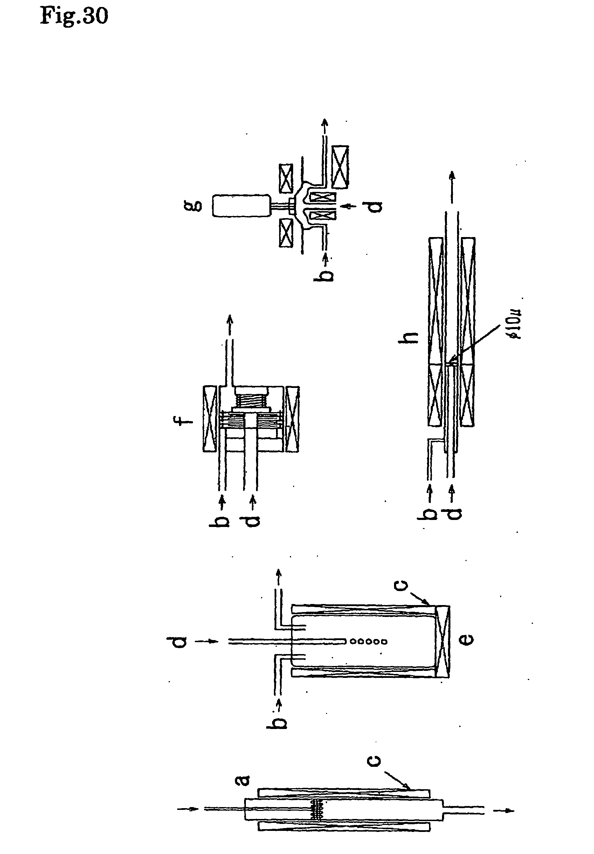

Figure 30 shows various types of vaporizers applicable to the present invention.

### INDUSTRIAL APPLICABILITY

According to the present invention, there is provided a vaporizer used for a film forming apparatus such as a MOCVD film forming apparatus, which can be used for a long period of time without being clogged, and can supply raw materials stably to a reaction section.

In this vaporizer, the occurrence of air bubbles can be restrained, and also variations in thin film deposition speed caused by the air bubbles can be expected to be restrained.

## Claims

1. A vaporizer comprising:
(1) a dispersion section having
a gas passage formed in the interior,
a gas introduction port for introducing a carrier gas into said gas passage,
means for supplying a raw material solution to said gas passage,
a gas outlet for sending the carrier gas containing the raw material solution to a vaporization section, and
means for cooling said gas passage; and
(2) the vaporization section for heating and vaporizing the carrier gas containing the atomized raw material solution, which is sent from said dispersion section, having
a vaporization tube one end of which is connected to a reaction section of film forming apparatus or other various types of apparatuses and the other end of which is connected to said gas outlet, and
heating means for heating said vaporization tube, **characterized in that**
the pressure of the reaction section is set lower than the pressure of said vaporization tube.

2. The vaporizer according to claim 1, **characterized in that** the film forming apparatus is a normal-pressure CVD apparatus in which the pressure of the reaction section is controlled to 900 to 760 Torr.

3. The vaporizer according to claim 1, **characterized in that** the film forming apparatus is a depressurized CVD apparatus in which the pressure of the reaction section is controlled to 20 to 0.1 Torr.

4. The vaporizer according to claim 1, **characterized in that** the film forming apparatus is a low-pressure CVD apparatus in which the pressure of the reaction section is controlled to 0.1 to 0.001 Torr.

5. A vaporizer comprising:
(1) a dispersion section having
a gas passage formed in the interior,
a gas introduction port for introducing a carrier gas into said gas passage,
means for supplying a raw material solution to said gas passage,
a gas outlet for sending the carrier gas containing the raw material solution to a vaporization section, and
means for cooling said gas passage; and
(2) the vaporization section for heating and vaporizing the carrier gas containing the raw material solution, which is sent from said dispersion section, having
a vaporization tube one end of which is connected to a reaction section of film forming apparatus or other various types of apparatuses and the other end of which is connected to said gas outlet, and
heating means for heating said vaporization tube, **characterized in that**
(3) said dispersion section has a dispersion section body having a cylindrical or conical hollow portion and a rod having an outside diameter smaller than the inside diameter of said cylindrical or conical hollow portion,
said rod has one or two or more spiral grooves on the vaporizer side at the outer periphery of said rod, and is inserted in said cylindrical or conical hollow portion, the inside diameter thereof sometimes spreading in a taper shape toward the vaporizer side, and
the pressure of the reaction section is set lower than the pressure of said vaporization tube.

6. The vaporizer according to claim 5, **characterized in that** the film forming apparatus is a normal-pressure CVD apparatus in which the pressure of the reaction section is controlled to 900 to 760 Torr.

7. The vaporizer according to claim 5, **characterized in that** the film forming apparatus is a depressurized CVD apparatus in which the pressure of the reaction section is controlled to 20 to 0.1 Torr.

8. The vaporizer according to claim 5, **characterized in that** the film forming apparatus is a low-pressure CVD apparatus in which the pressure of the reaction section is controlled to 0.1 to 0.001 Torr.

9. A vaporizer comprising:
(1) a dispersion section having
a gas passage formed in the interior,
a gas introduction port for introducing a carrier gas into said gas passage,
means for supplying a raw material solution to said gas passage,
a gas outlet for sending the carrier gas containing the raw material solution to a vaporization section, and
means for cooling said gas passage; and
(2) the vaporization section for heating and vaporizing the carrier gas containing the raw material solution, which is sent from said dispersion section, having
a vaporization tube one end of which is connected to a reaction section of film forming apparatus or other various types of apparatuses and the other end of which is connected to said gas outlet, and
heating means for heating said vaporization tube, **characterized in that**
an oxidizing gas can be added to the carrier gas from said gas introduction port or an oxidizing gas can be introduced from a primary oxygen supply port, and
the pressure of the reaction section is set lower than the pressure of said vaporization tube.

10. The vaporizer according to claim 9, **characterized in that** the film forming apparatus is a normal-pressure CVD apparatus in which the pressure of the reaction section is controlled to 900 to 760 Torr.

11. The vaporizer according to claim 9, **characterized in that** the film forming apparatus is a depressurized CVD apparatus in which the pressure of the reaction section is controlled to 20 to 0.1 Torr.

12. The vaporizer according to claim 9, **characterized in that** the film forming apparatus is a low-pressure CVD apparatus in which the pressure of the reaction section is controlled to 0.1 to 0.001 Torr.

13. A vaporizer comprising:
(1) a dispersion section having
a gas passage formed in the interior,
a gas introduction port for introducing a carrier gas into said gas passage,
means for supplying a raw material solution to said gas passage,
a gas outlet for sending the carrier gas containing the raw material solution to a vaporization section, and
means for cooling said gas passage; and
(2) the vaporization section for heating and vaporizing the carrier gas containing the raw material solution, which is sent from said dispersion section, having
a vaporization tube one end of which is connected to a reaction section of film forming apparatus or other various types of apparatuses and the other end of which is connected to said gas outlet, and
heating means for heating said vaporization tube, **characterized in that**
a radiation preventive portion having a minute hole is provided on the outside of said gas outlet,
the carrier gas and an oxidizing gas can be introduced from said gas introduction port, and
the pressure of the reaction section is set lower than the pressure of said vaporization tube.

14. The vaporizer according to claim 13, **characterized in that** the film forming apparatus is a normal-pressure CVD apparatus in which the pressure of the reaction section is controlled to 900 to 760 Torr.

15. The vaporizer according to claim 13, **characterized in that** the film forming apparatus is a depressurized CVD apparatus in which the pressure of the reaction section is controlled to 20 to 0.1 Torr.

16. The vaporizer according to claim 13, **characterized in that** the film forming apparatus is a low-pressure CVD apparatus in which the pressure of the reaction section is controlled to 0.1 to 0.001 Torr.

17. A vaporizer comprising:
a disperser formed with
a plurality of solution passages for supplying a plurality of raw material solutions,
a mixing section for mixing said raw material solutions supplied from said solution passages,
a supply passage one end of which communicates with said mixing section and which has an outlet on the vaporization section side,
a gas passage arranged so that a carrier gas or a mixed gas of the carrier gas and oxygen is blown to the mixed raw material solution coming from said mixing section in the supply passage, and
cooling means for cooling said supply passage; and
a vaporization section for heating and vaporizing the carrier gas containing the raw material solutions, which is sent from said disperser, having
a vaporization tube one end of which is connected to a reaction section of a film forming apparatus or other various types of apparatuses and the other end of which is connected to the outlet of said disperser, and
heating means for heating said vaporization tube, **characterized in that**
a radiation preventive portion having a minute hole is provided on the outside of said outlet,
a primary oxygen supply port capable of introducing an oxidizing gas is provided just near said dispersion blowoff portion, and
the pressure of the reaction section is set lower than the pressure of said vaporization tube.

18. The vaporizer according to claim 17, **characterized in that** the film forming apparatus is a normal-pressure CVD apparatus in which the pressure of the reaction section is controlled to 900 to 760 Torr.

19. The vaporizer according to claim 17, **characterized in that** the film forming apparatus is a depressurized CVD apparatus in which the pressure of the reaction section is controlled to 20 to 0.1 Torr.

20. The vaporizer according to claim 17, **characterized in that** the film forming apparatus is a low-pressure CVD apparatus in which the pressure of the reaction section is controlled to 0.1 to 0.001 Torr.

21. A film forming apparatus including the vaporizer as described in any one of claims 1 to 20.

22. A vaporizing method in which a raw material solution is introduced into a gas passage, and a carrier gas is sprayed toward the introduced raw material solution, by which said raw material solution is sheared and atomized into raw material mist, and then, said raw material mist is supplied to a vaporization section to be vaporized,
**characterized in that**
control is carried out so that the pressures of said carrier gas and said introduced raw material solution are almost equal in a region in which said carrier gas comes into contact with said introduced raw material solution.

23. A vaporizing method in which a raw material solution is introduced into a gas passage, and a carrier gas is sprayed toward the introduced raw material solution, by which said raw material solution is sheared and atomized into raw material mist, and then, said raw material mist is supplied to a vaporization section to be vaporized, **characterized in that**
control is carried out so that the pressure of said carrier gas is lower than the pressure of said introduced raw material solution in a region in which said carrier gas comes into contact with said introduced raw material solution.

24. The vaporizing method according to claim 23, **characterized in that** control is carried out so that the pressure of said carrier gas is lower than the pressure of said introduced raw material solution by 760 Torr at a maximum in a region in which said carrier gas comes into contact with said introduced raw material solution.

25. The vaporizing method according to claim 40, **characterized in that** control is carried out so that the pressure of said carrier gas is lower than the pressure of said introduced raw material solution by 100 to 10 Torr at a maximum in a region in which said carrier gas comes into contact with said introduced raw material solution.

26. A vaporizing method in which a raw material solution is introduced into a gas passage, and a carrier gas is sprayed toward the introduced raw material solution, by which said raw material solution is sheared and atomized into raw material mist, and then, said raw material mist is supplied to a vaporization section to be vaporized, **characterized in that**
control is carried out so that the pressures of said carrier gas and said raw material solution are higher than the vapor pressure of said introduced raw material solution in a region in which said carrier gas comes into contact with said introduced raw material solution.

27. The vaporizing method according to claim 26, in which a raw material solution is introduced into a gas passage, and a carrier gas is sprayed toward the introduced raw material solution, by which said raw material solution is sheared and atomized into raw material mist, and then, said raw material mist is supplied to a vaporization section to be vaporized, **characterized in that**
control is carried out so that the pressures of said carrier gas and said raw material solution are 1.5 times or more higher than the vapor pressure of said introduced raw material solution in a region in which said carrier gas comes into contact with said introduced raw material solution.

28. The vaporizing method according to any one of claims 22 to 27, **characterized in that** oxygen is contained in said carrier gas in advance.

29. A film **characterized by** being formed after vaporization is accomplished by the vaporizing method as described in any one of claims 22 to 28.

30. An electronic device including the film as described in claim 29.

31. A CVD thin film forming method **characterized in that** after a pressurizing gas dissolved in a transfer solution using the pressurizing gas has been removed, the flow rate is controlled, and the vaporizer is connected to a CVD apparatus to form a thin film.

32. The CVD thin film deposition forming method according to claim 31, **characterized in that** the transfer solution using said pressurizing gas is caused to flow in a fluororesin pipe in which transmission speed is controlled, whereby only said pressurizing gas is removed.

33. The CVD thin film deposition forming method according to claim 31 or 32, **characterized in that** when only said pressurizing gas is removed by causing the transfer solution using said pressurizing gas to flow in a fluororesin pipe etc. in which transmission speed is controlled, the removal of said pressuring gas is accelerated by controlling the external environment of said fluororesin pipe etc.

34. A vaporizing method in which a raw material solution is introduced into a passage and introduced into a depressurized and heated vaporizer, and is sprayed or dripped into said vaporizer, whereby said raw material solution is atomized and vaporized, **characterized in that** control is carried out so that the pressure of said raw material solution in the tip end portion of said passage is higher than the vapor pressure of the introduced raw material solution.

35. The vaporizing method according to claim 34, **characterized in that** control is carried out so that the pressure of said raw material solution is 1.5 times or more the vapor pressure of the introduced raw material solution in the tip end portion of said passage.

36. A vaporizing method in which a raw material solution and a carrier gas are introduced into a depressurized and heated vaporizer, and are sprayed into said vaporizer, whereby said raw material solution is atomized and vaporized, **characterized in that** control is carried out so that the pressure of said raw material solution in the tip end portion of said passage is higher than the vapor pressure of the introduced raw material solution.

37. The vaporizing method according to claim 36, **characterized in that** control is carried out so that the pressure of said raw material solution is 1.5 times or more the vapor pressure of said raw material solution in the tip end portion of said passage.

38. The vaporizing method according to claim 35 or 37, **characterized in that** oxygen is contained in said carrier gas in advance.

39. The vaporizing method according to any one of claims 35 to 38, **characterized in that** control is carried out so that the pressures of said carrier gas and said introduced raw material solution are almost equal in a region in which said carrier gas comes into contact with said introduced raw material solution.

40. The vaporizing method according to any one of claims 35 to 38, **characterized in that** control is carried out so that the pressure of said carrier gas is lower than the pressure of said introduced raw material solution in a region in which said carrier gas comes into contact with said introduced raw material solution.

41. The vaporizing method according to claim 40, **characterized in that** control is carried out so that the pressure of said carrier gas is lower than the pressure of said introduced raw material solution by 760 Torr at a maximum in a region in which said carrier gas comes into contact with said introduced raw material solution.

42. The vaporizing method according to claim 41, **characterized in that** control is carried out so that the pressure of said carrier gas is lower than the pressure of said introduced raw material solution by 100 to 10 Torr at a maximum in a region in which said carrier gas comes into contact with said introduced raw material solution.

43. The vaporizing method according to any one of claims 35 to 38, **characterized in that** control is carried out so that the pressures of said carrier gas and said raw material solution are higher than the vapor pressure of said introduced raw material solution in a region in which said carrier gas comes into contact with said introduced raw material solution.

44. The vaporizing method according to claim 43, **characterized in that** control is carried out so that the pressures of said carrier gas and said raw material solution are 1.5 times or more higher than the vapor pressure of said introduced raw material solution in a region in which said carrier gas comes into contact with said introduced raw material solution.

45. A CVD thin film forming apparatus in which a transfer solution using a pressurizing gas is introduced into the vaporizer via a mass-flow controller, and the vaporizer is connected to the CVD apparatus, whereby a thin film is formed, **characterized in that** degassing means for removing a pressuring gas is provided on the upstream side of said mass-flow controller.
